# EUROPEAN PATENT APPLICATION

(11) **EP 4 776 808 A2**
(43) Date of publication of application: **15.07.2026**
(21) Application number: 25219213.3
(22) Date of filing: 27.11.2025
(51) Int. Cl.: H10K 59/131, G09G 3/3233, H10D 30/67, H10D 86/40, H10D 86/60

(54) **DISPLAY PANEL AND DISPLAY DEVICE**

(30) Priority: 18.12.2024 CN 202411874829
(71) Applicant: Tianma Advanced Display Technology Institute (Xiamen) Co., Ltd., Xiamen, Fujian 361101 (CN)
(72) Inventor: JIA, Zhenyu, Xiamen, Fujian, 361101 (CN); ZHOU, Zhimin, Xiamen, Fujian, 361101 (CN); ZHAI, Yingteng, Xiamen, Fujian, 361101 (CN); LI, Xiao, Xiamen, Fujian, 361101 (CN)
(74) Representative: Germain Maureau

(57) **Abstract**

A display panel includes a base substrate and a pixel driving circuit disposed on a side of the base substrate; the pixel driving circuit includes a first drive transistor, and the first drive transistor includes a first electrode and a second electrode; the first electrode includes a first section extending in a first direction, and the second electrode includes a second section extending in a second direction; the first section includes a first segment and a second segment arranged in the first direction, a vertical projection of the second segment on a base substrate overlaps a vertical projection of the second section on the base substrate, and in the first direction, an area per unit length of the second segment is less than an area per unit length of the first segment.

## Description

This application claims priority to Chinese Patent Application No. 202411874829.4 filed on December 18, 2024.

### TECHNICAL FIELD

The present disclosure relates to the field of display technologies, and in particular, to a display panel and a display device.

### BACKGROUND

Light-emitting diode (LED) display panels are widely used in various types of display devices due to the advantages of higher brightness level, better light-emitting efficiency, and lower power consumption.

In a display panel, a pixel driving circuit includes a large number of transistors and has a relatively complex circuit structure. With the demand for high-resolution display, the transistors and wires such as signal lines correspondingly connected to the transistors need to be arranged within the limited space. As a result, the transistors and the wires are intensively distributed, which increases the mutual interference among the signal nodes and further affects the driving capability of the pixel driving circuit.

### SUMMARY

The present disclosure provides a display panel and a display device, to solve the problem of the mutual interference among the node signals in a pixel driving circuit and to improve the driving capability of the pixel driving circuit.

The present disclosure provides a display panel, which includes a base substrate and a pixel driving circuit disposed on a side of the base substrate. The pixel driving circuit includes a first drive transistor. The first drive transistor includes a first electrode and a second electrode. The first electrode includes a first section extending in a first direction. The second electrode includes a second section extending in a second direction. The first direction intersects with the second direction. The first section includes a first segment and a second segment arranged in the first direction, and a vertical projection of the second segment on the base substrate overlaps a vertical projection of the second section on the base substrate. In the first direction, an area per unit length of the second segment is less than an area per unit length of the first segment .

The present disclosure further provides a display device. The display device includes the display panel, which includes a base substrate and a pixel driving circuit disposed on a side of the base substrate. The pixel driving circuit includes a first drive transistor. The first drive transistor includes a first electrode and a second electrode. The first electrode includes a first section extending in a first direction. The second electrode includes a second section extending in a second direction. The first direction intersects with the second direction. The first section includes a first segment and a second segment arranged in the first direction, and a vertical projection of the second segment on the base substrate overlaps a vertical projection of the second section on the base substrate. In the first direction, an area per unit length of the second segment is less than an area per unit length of the first segment.

Other embodiments in the summary are as disclosed in the claims as appended.

It is to be understood that the contents described in this section are not intended to identify key or critical features of the embodiments of the present disclosure, nor intended to limit the scope of the present disclosure. Other features of the present disclosure will be readily understood from the following Description.

### BRIEF DESCRIPTION OF THE DRAWINGS

In order to more clearly explain technical solutions of embodiments of the present disclosure, the drawings used for describing the embodiments will be briefly introduced below. Apparently, the drawings in the following description are merely the drawings of part of the embodiments of the present disclosure. For those skilled in the art, other drawings may also be obtained without the exercise of inventive faculty according to these drawings.
FIG. 1 is a schematic structural diagram of a display panel according to an embodiment of the present disclosure;
FIG. 2 is a schematic sectional view taken along an A-A' direction of FIG. 1;
FIG. 3 is a schematic structural diagram of a pixel driving circuit according to an embodiment of the present disclosure;
FIG. 4 is a schematic diagram showing a film layer structure of the pixel driving circuit shown in FIG. 3;
FIG. 5 is an enlarged schematic structural diagram at a position B of FIG. 4;
FIG. 6 is an enlarged schematic structural diagram at a position C of FIG. 4;
FIG. 7 is another schematic diagram showing a film layer structure of the pixel driving circuit shown in FIG. 3;
FIG. 8 is an enlarged schematic structural diagram at a position D of FIG. 7;
FIG. 9 an enlarged schematic structural diagram at a position E of FIG. 7;
FIG. 10 is a schematic structural diagram of a first section and a second section according to an embodiment of the present disclosure;
FIG. 11 is another schematic structural diagram of a first section and a second section according to an embodiment of the present disclosure;
FIG. 12 is yet another schematic structural diagram of a first section and a second section according to an embodiment of the present disclosure;
FIG. 13 is yet another schematic structural diagram of a first section and a second section according to an embodiment of the present disclosure;
FIG. 14 is another schematic structural diagram of a pixel driving circuit according to an embodiment of the present disclosure;
FIG. 15 is a schematic diagram showing a film layer structure of a display panel according to an embodiment of the present disclosure;
FIG. 16 is a schematic structural diagram of a first metal layer in the display panel shown in FIG. 15;
FIG. 17 is a schematic structural diagram of a semiconductor layer in the display panel shown in FIG. 15;
FIG. 18 is a schematic structural diagram of a second metal layer in the display panel shown in FIG. 15;
FIG. 19 is a schematic structural diagram of a third metal layer in the display panel shown in FIG. 15;
FIG. 20 is a schematic structural diagram of a fourth metal layer in the display panel shown in FIG. 15;
FIG. 21 is a schematic diagram showing a laminated structure of all film layers from a first metal layer to a fourth metal layer in the display panel shown in FIG. 15;
FIG. 22 is an enlarged schematic structural diagram at a position F of FIG. 21;
FIG. 23 is an enlarged schematic structural diagram at a position G of FIG. 21;
FIG. 24 is a schematic structural diagram of a third section and a first connection section according to an embodiment of the present disclosure;
FIG. 25 is another schematic structural diagram of a first metal layer in the display panel shown in FIG. 15;
FIG. 26 is another schematic structural diagram of a semiconductor layer in the display panel shown in FIG. 15;
FIG. 27 is another schematic structural diagram of a second metal layer in the display panel shown in FIG. 15;
FIG. 28 is another schematic structural diagram of a third metal layer in the display panel shown in FIG. 15;
FIG. 29 is another schematic structural diagram of a fourth metal layer in the display panel shown in FIG. 15;
FIG. 30 is another schematic diagram showing a laminated structure of all film layers in the display panel shown in FIG. 15;
FIG. 31 is a schematic structural diagram of a gate of a pulse width drive transistor and a second connection section according to an embodiment of the present disclosure;
FIG. 32 is a schematic structural diagram of a display device according to an embodiment of the present disclosure; and
FIG. 33 is another schematic structural diagram of a display device according to an embodiment of the present disclosure.

### DETAILED DESCRIPTION

In order that those skilled in the art will better understand the solutions of the present disclosure, the technical solutions of embodiments of the present disclosure will be clearly and completely described below in conjunction with the drawings of the embodiments of the present disclosure. Apparently, the described embodiments are merely some embodiments of the present disclosure, rather than all of the embodiments. All other embodiments obtained by those of ordinary skill in the art based on the embodiments of the present disclosure without needing creative efforts shall all fall in the scope of protection of the present disclosure.

It is to be noted that the terms "first", "second" and the like in the Description and claims of the present disclosure, and in the drawings, are used for distinguishing between similar objects and not necessarily for describing a particular order or sequential order. It is to be understood that the data so used are interchangeable as appropriate so that the embodiments of the present disclosure described herein can be implemented in an order other than those illustrated or described herein. Moreover, the terms "include" and "have" as well as any variations thereof, are intended to cover a non-exclusive inclusion, for example, a process, a method, a system, a product, or a device that includes a series of steps or units is not necessarily limited to those steps or units expressly listed, but may include other steps or units not expressly listed or inherent to such process, method, product, or device.

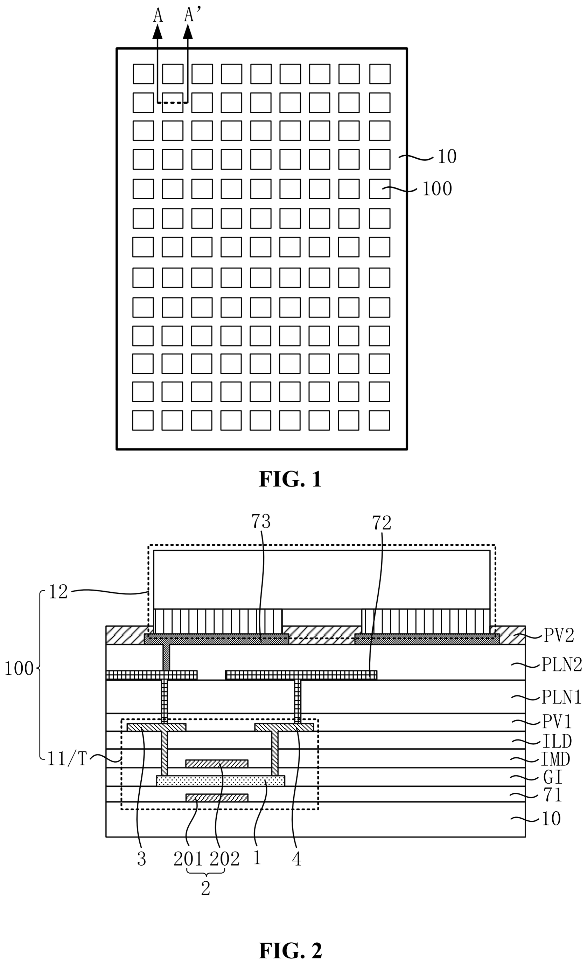

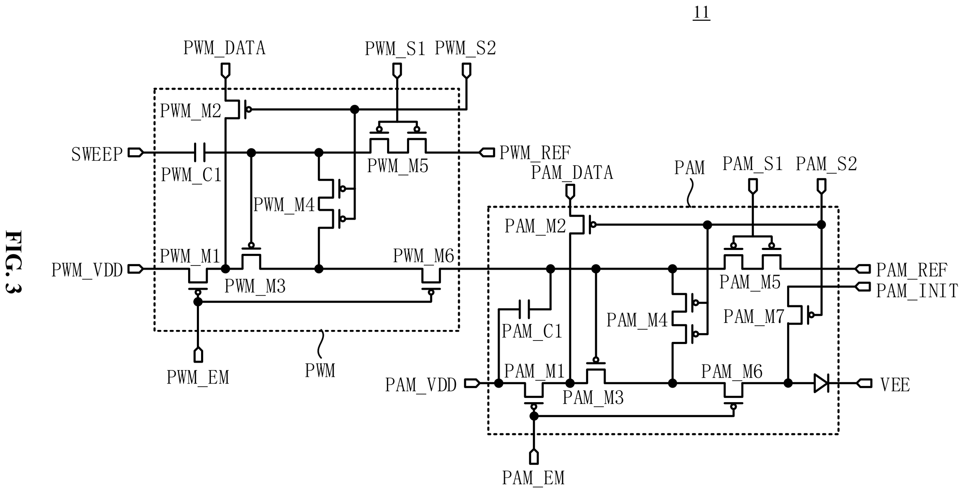

FIG. 1 is a schematic structural diagram of a display panel according to an embodiment of the present disclosure, FIG. 2 is a schematic sectional view taken along an A-A' direction of FIG. 1, and FIG. 3 is a schematic structural diagram of a pixel driving circuit according to an embodiment of the present disclosure. As shown in FIGS. 1 to 3, the display panel provided in the embodiments of the present disclosure includes a base substrate 10 and a pixel driving circuit 11 located on a side of the base substrate 10. The pixel driving circuit 11 includes a first drive transistor M3, and the first drive transistor M3 includes a first electrode M31 and a second electrode M32. The first electrode M31 includes a first section 21 extending in a first direction X, the second electrode M32 includes a second section 22 extending in a second direction Y, and the first direction X intersects with the second direction Y. The first section 21 includes a first segment 211 and a second segment 212 arranged in the first direction X, and a vertical projection of the second segment 212 on the base substrate 10 overlaps a vertical projection of the second section 22 on the base substrate 10. In the first direction X, an area per unit length of the second segment 212 is less than an area per unit length of the first segment 211 .

In one or more embodiments, as shown in FIGS. 1 and 2, multiple pixel driving circuits 11 arranged in an array and multiple light-emitting elements 12 arranged in an array are disposed on a side of a base substrate 10. The multiple pixel driving circuits 11 are correspondingly electrically connected to the multiple light-emitting elements 12. The pixel driving circuit 11 is configured to transmit a drive current to the light-emitting element 12 in response to a signal on a drive signal line (such as a scan signal line, a data signal line, a power signal line, etc.) on the display panel, to drive the light-emitting element 12 to emit light. The light-emitting element 12 and the pixel driving circuit 11 electrically connected to the light-emitting element 12 together constitute a sub-pixel 100 of the display panel, multiple sub-pixels 100 are arranged according to a certain rule, and the brightness levels of different sub-pixels 100 are accurately controlled to achieve the display of an image completely.

It is to be noted that, the arrangement manner of the multiple pixel driving circuits 11 and the multiple light-emitting elements 12 may be set according to actual requirements, which is not limited in the embodiments of the present disclosure.

With continued reference to FIG. 2, in one or more embodiments, the pixel driving circuit 11 may include at least one thin film transistor T, and the thin film transistor T may include an active layer 1, a gate 2, a source 3 and a drain 4.

The gate 2 may include a bottom gate 201 and a top gate 202, to form a double-gate transistor, thereby reducing a leakage current in the thin film transistor T, and further reducing the influence of the leakage current on the potential of each node in the pixel driving circuit 11.

With continued reference to FIG. 2, in one or more embodiments, a bottom gate insulating layer 71 may be disposed between the bottom gate 201 and the active layer 1, a gate insulating layer GI may be disposed between the active layer 1 and the top gate 202, and an interlayer dielectric layer IMD and an insulating intermediate layer ILD may be disposed between the top gate 202 and the source 3. A first passivation layer PV1, a first planarization layer PLN1, a first connection metal layer 72, a second planarization layer PLN2, and a second connection metal layer 73 and a second passivation layer PV2 are sequentially disposed on a side of the source 3 away from the base substrate 10, but the embodiments of the present disclosure are not limited thereto.

Further, the light-emitting element 12 may include a miniature light-emitting diode (such as a Micro-LED or a Mini-LED), and the miniature light-emitting diode offers a higher brightness level and has a longer service life, so that the display requirements in outdoor or high-brightness level environments may be satisfied, but the embodiments of the present disclosure are not limited thereto.

In other embodiments, the light-emitting element 12 may also be an organic light-emitting diode (OLED) or other types of light-emitting devices, which is not limited in the embodiments of the present disclosure.

With continued reference to FIG. 3, in one or more embodiments, the thin film transistor T in the pixel driving circuit 11 includes a first drive transistor M3, and the first drive transistor M3 is configured to transmit a voltage or a drive current to a node based on a gate voltage of the first drive transistor M3. For example, the first drive transistor M3 may be turned on according to a gate potential of the first drive transistor M3 and generate a drive current, and may transmit the drive current to the light-emitting element 12 to drive the light-emitting element 12 to emit light, but the embodiments of the present disclosure are not limited thereto.

In an example, as shown in FIG. 3, the pixel driving circuit 11 includes a pulse width adjustment module PWM and an amplitude adjustment module PAM. The pulse width adjustment module PWM includes a pulse width drive transistor PWM_M3, and the amplitude adjustment module PAM includes an amplitude drive transistor PAM_M3. The pulse width drive transistor PWM_M3 is electrically connected to a gate of the amplitude drive transistor PAM_M3, and the first drive transistor M3 includes at least one of the amplitude drive transistor PAM_M3 or the pulse width drive transistor PWM_M3.

The amplitude adjustment module PAM is configured to provide a drive current to the light-emitting element 12 and control the light-emitting efficiency of the light-emitting element 12 by adjusting the amplitude of the drive current.

In one or more embodiments, the drive current may be a constant drive current, so that the light-emitting element 12 is driven by using a better drive current, thereby ensuring that the light-emitting element 12 works in an optimal state, which is conducive to achieving the higher light-emitting efficiency and the better display effect.

The pulse width adjustment module PWM is configured to control a duration for the amplitude adjustment module PAM to provide the drive current to the light-emitting element 12, to control a light-emitting duration of the light-emitting element 12. It is to be understood that, the light-emitting duration of the light-emitting element 12 is controlled (that is, the light-emitting duty ratio of the light-emitting element 12 is adjusted), so that the brightness level of the light emitted by the light-emitting element 12 may be controlled.

Therefore, in the pixel driving circuit 11 provided in this embodiment, the gray scale or the brightness level displayed by the light-emitting element 12 may be adjusted by both the pulse width adjustment module PWM and the amplitude adjustment module PAM.

Further, as shown in FIG. 3, in the amplitude adjustment module PAM, the amplitude drive transistor PAM_M3 is connected in series between a second power line PAM_VDD and the light-emitting element 12, the second power line PAM_VDD is configured to provide a second power voltage, and the amplitude drive transistor PAM_M3 may generate a drive current based on a gate voltage of the amplitude drive transistor PAM_M3 and the second power voltage, to drive the light-emitting element 12 to emit light. The constant drive current may be generated by supplying the same voltage signal to the gate of the amplitude drive transistor PAM_M3.

It is to be noted that, for pixel driving circuits 11 connected to light-emitting elements 12 of different colors, different voltage signals may be provided to gates of amplitude drive transistors PAM_M3 of the pixel driving circuits 11, which is not limited in the embodiments of the present disclosure.

With continued reference to FIG. 3, in one or more embodiments, in the pulse width adjustment module PWM, the pulse width drive transistor PWM_M3 is connected in series between the first power line PWM_VDD and the gate of the amplitude drive transistor PAM_M3 and is configured to transmit a first power voltage provided by the first power line PWM_VDD to the gate of the amplitude drive transistor PAM_M3, to control the amplitude drive transistor PAM_M3 to be cut off, so that the pulse width adjustment module PWM may control a turn-on duration of the amplitude drive transistor PAM_M3, that is, the pulse width adjustment module PWM may control the duration of the drive current, to enable the light-emitting element 12 to emit light with brightness level corresponding to a gray scale.

In a case where the first power voltage controls the amplitude drive transistor PAM_M3 to be cut off, when the amplitude drive transistor PAM_M3 is a P-type transistor, the first power voltage may be a high level; otherwise, when the amplitude drive transistor PAM_M3 is an N-type transistor, the first power voltage may be a low level, which is not limited in the embodiments of the present disclosure.

It is to be understood that, the amplitude drive transistor PAM_M3 and the pulse width drive transistor PWM_M3 have an important function in the pixel driving circuit 11. The performance of the amplitude drive transistor PAM_M3 may directly affect the amplitude of the drive current, thereby affecting the light-emitting efficiency of the light-emitting element 12. The performance of the pulse width drive transistor PWM_M3 may directly affect the light-emitting time of the light-emitting element 12 and further affect the control of the gray scale of the light-emitting element 12.

It is to be noted that, FIG. 3 exemplarily shows a circuit structure of a 13T2C (i.e., including 13 transistors and 2 capacitors), but the embodiments of the present disclosure are not limited thereto. In other embodiments, the pixel driving circuit 11 may also adopt other circuit structures, for example, circuit structures of 17T3C (i.e., including 17 transistors and 3 capacitors), 7T1C (i.e., including 7 transistors and 1 capacitor), or 8T1C (i.e., including 8 transistors and 1 capacitor), which is not limited in the embodiments of the present disclosure.

Further, it is found through research that, since the pixel driving circuit 11 includes a large number of transistors and has a relatively complex circuit structure. With the demand for high-resolution display, the transistors and wires such as signal lines correspondingly connected to the transistors need to be arranged within the limited space. As a result, the transistors and the wires are intensively distributed, which will increase the mutual interference among the signal nodes and further affect the driving capability of the pixel driving circuit 11.

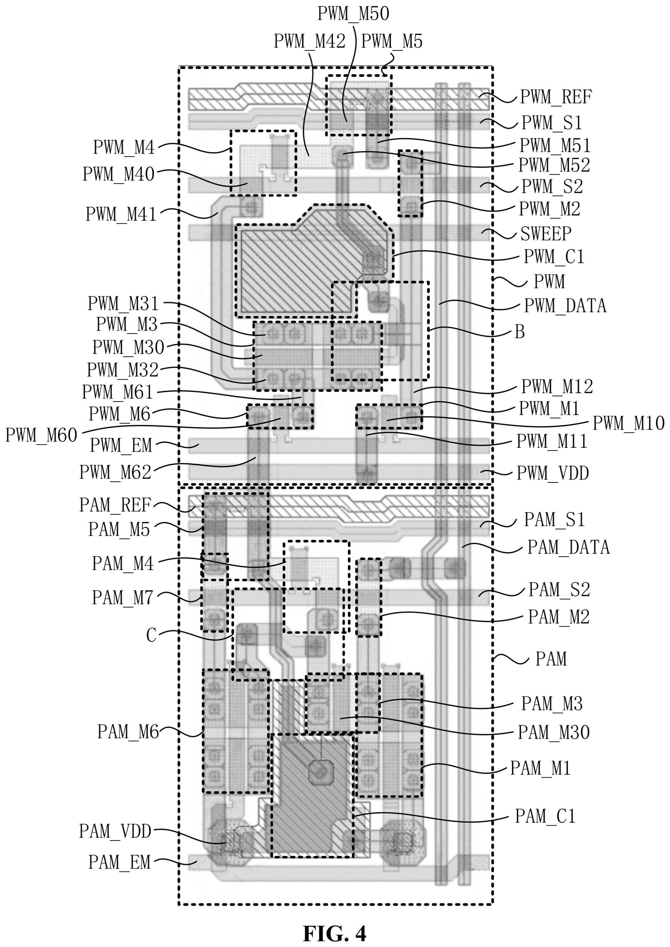

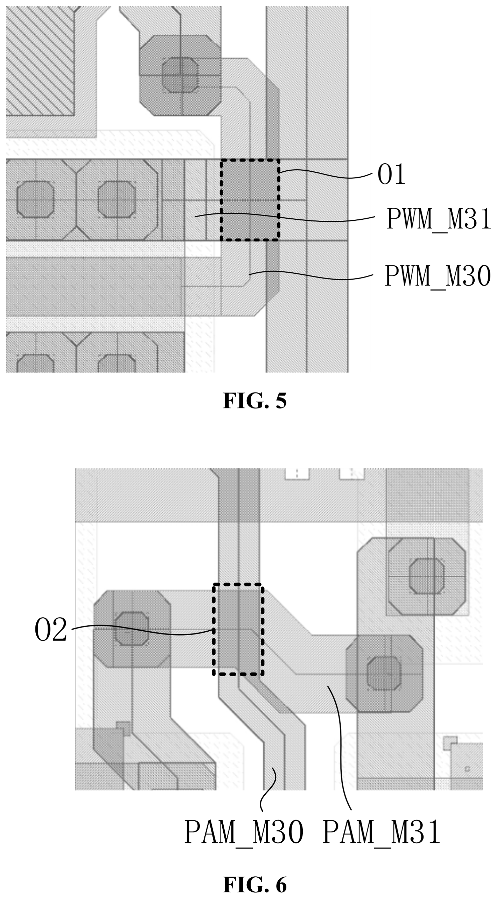

In an example, FIG. 4 is a schematic diagram showing a film layer structure of the pixel driving circuit shown in FIG. 3, FIG. 5 is an enlarged schematic structural diagram at a position B of FIG. 4, and FIG. 6 is an enlarged schematic structural diagram at a position C of FIG. 4. As shown in FIGS. 4 to 6, a gate PWM_M30 of the pulse width drive transistor PWM_M3 and a first terminal PWM_M31 (such as a source of the pulse width drive transistor PWM_M3) of the pulse width drive transistor PWM_M3 are disposed in an insulated and intersecting manner; therefore, a first overlapping region O1 exists between the gate PWM_M30 of the pulse width drive transistor PWM_M3 and the first terminal PWM_M31 of the pulse width drive transistor PWM_M3. The gate PWM_M30 of the pulse width drive transistor PWM_M3 and the first terminal PWM_M31 of the pulse width drive transistor PWM_M3 are both located on the base substrate, in a direction perpendicular to a plane where the base substrate is located, a distance between the gate PWM_M30 of the pulse width drive transistor PWM_M3 and the first terminal PWM_M31 of the pulse width drive transistor PWM_M3 is relatively short, as a result, a relatively large parasitic capacitance is formed between the gate PWM_M30 of the pulse width drive transistor PWM_M3 and the first terminal PWM_M31 of the pulse width drive transistor PWM_M3 in the first overlapping region O1. In this way, when a voltage is applied to the gate PWM_M30 to turn on the pulse width drive transistor PWM_M3, part of the energy may be consumed on the parasitic capacitance, the unnecessary coupling power consumption is caused, and an actual voltage of the gate PWM_M30 is decreased, so that the voltage of the gate PWM_M30 of the pulse width drive transistor PWM_M3 cannot reach an expected turn-on voltage. Moreover, the voltage of the gate PWM_M30 will also be interfered by the change of the voltage of the first terminal PWM_M31; therefore, an unpredictable deviation between the voltage of the gate PWM_M30 and the expected turn-on voltage is caused, so that the actual voltage of the gate PWM_M30 cannot be accurately controlled, and the control difficulty of the pixel driving circuit 11 is increased. The above problems finally affect the driving capability of the pixel driving circuit 11.

It is to be noted that, in FIGS. 4 and 5, only an example in which an overlapping exists between the gate PWM_M30 of the pulse width drive transistor PWM_M3 and the first terminal PWM_M31 of the pulse width drive transistor PWM_M3 is used for illustration. When the connection relationship of the pulse width drive transistor PWM_M3 changes, an overlapping also exists between the gate PWM_M30 of the pulse width drive transistor PWM_M3 and a drain of the pulse width drive transistor PWM_M3, which is not limited in the embodiments of the present disclosure.

Similarly, as shown in FIGS. 4 and 6, a gate PAM_M30 of the amplitude drive transistor PAM_M3 and a first terminal PAM_M31 (such as a source of the amplitude drive transistor PAM_M3) of the amplitude drive transistor PAM_M3 are disposed in an insulated and intersecting manner; therefore, a second overlapping region O2 exists between the gate PAM_M30 of the amplitude drive transistor PAM_M3 and the first terminal PAM_M31 of the amplitude drive transistor PAM_M3. The gate PAM_M30 of the amplitude drive transistor PAM_M3 and the first terminal PAM_M31 of the amplitude drive transistor PAM_M3 are both located on the base substrate, in the direction perpendicular to the plane where the base substrate is located, a distance between the gate PAM_M30 of the amplitude drive transistor PAM_M3 and the first terminal PAM_M31 of the amplitude drive transistor PAM_M3 is relatively short, as a result, a relatively large parasitic capacitance is formed between the gate PAM_M30 of the amplitude drive transistor PAM_M3 and the first terminal PAM_M31 of the amplitude drive transistor PAM_M3 in the second overlapping region O2. In this way, when a voltage is applied to the gate PAM_M30 to turn on the amplitude drive transistor PAM_M3, part of the energy may be consumed on the parasitic capacitance, unnecessary coupling power consumption is caused, and an actual voltage of the gate PAM_M30 is decreased, so that the voltage of the gate PAM_M30 of the amplitude drive transistor PAM_M3 cannot reach an expected turn-on voltage, thereby resulting in insufficient drive current and making the display brightness level lower than expected. Moreover, the voltage of the gate PAM_M30 is further interfered with by the change of the voltage of the first terminal PAM_M31; therefore, an unpredictable deviation between the voltage of the gate PAM_M30 and the expected turn-on voltage is caused, so that the actual voltage of the gate PAM_M30 cannot be accurately controlled, and the control difficulty of the pixel driving circuit 11 is increased. The above problem finally affects the driving capability of the pixel driving circuit 11.

It is to be noted that in FIGS. 4 and 6, only an example in which an overlapping exists between the gate PAM_M30 of the amplitude drive transistor PAM_M3 and the first terminal PAM_M31 of the amplitude drive transistor PAM_M3 is used for illustration. When the connection relationship of the amplitude drive transistor PAM_M3 changes, an overlapping also exists between the gate PAM_M30 of the amplitude drive transistor PAM_M3 and a drain of the amplitude drive transistor PAM_M3, which is not limited in the embodiments of the present disclosure.

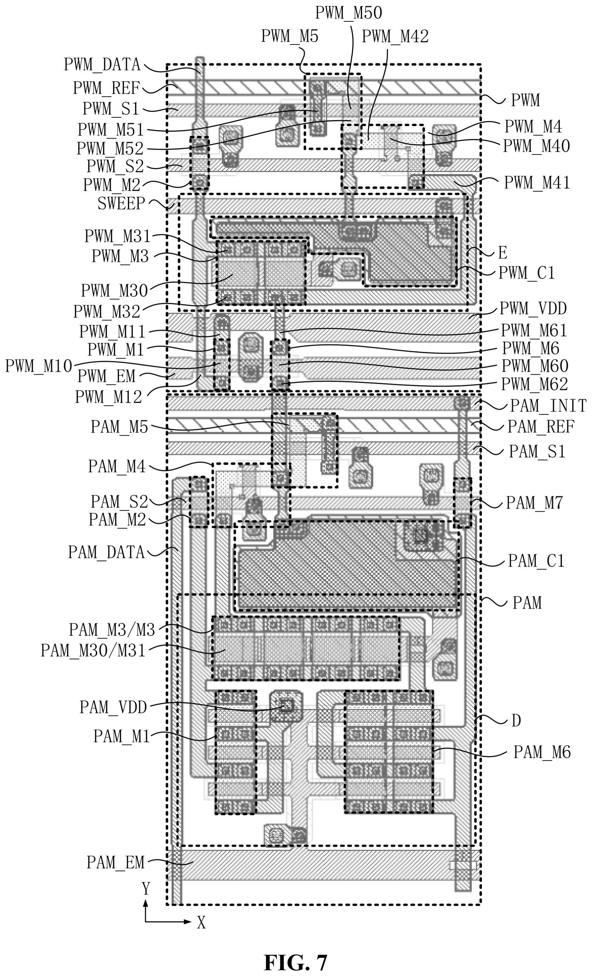

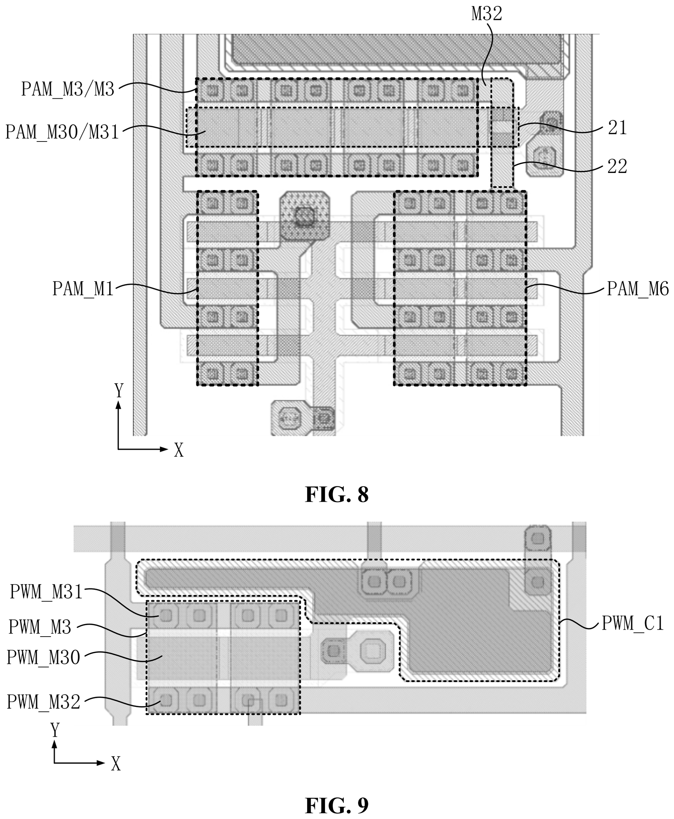

Based on the above-described technical problems, FIG. 7 is another schematic diagram showing a film layer structure of the pixel driving circuit shown in FIG. 3, FIG. 8 is an enlarged schematic structural diagram at a position D of FIG. 7, and FIG. 9 an enlarged schematic structural diagram at a position E of FIG. 7. As shown in FIGS. 7 to 9, in this embodiment, at least one of the amplitude drive transistor PAM_M3 or the pulse width drive transistor PWM_M3 is used as the first drive transistor M3, that is, the first drive transistor M3 may be the amplitude drive transistor PAM_M3, or the first drive transistor M3 is the pulse width drive transistor PWM_M3, or the first drive transistor M3 includes the amplitude drive transistor PAM_M3 and the pulse width drive transistor PWM_M3, which is not limited in the embodiments of the present disclosure.

As shown in FIG. 7 to FIG. 9, an example in which the first drive transistor M3 is used as the amplitude drive transistor PAM_M3 is used for illustration. An electrode of the first drive transistor M3 includes the first electrode M31 and the second electrode M32, and the first section 21 in the first electrode M31 and the second section 22 in the second electrode M32 are disposed in an intersecting manner. As shown in FIG. 8, the first section 21 extends in the first direction X, and the second section 22 extends in the second direction Y. In this case, an overlapping region is formed between the first section 21 and the second section 22.

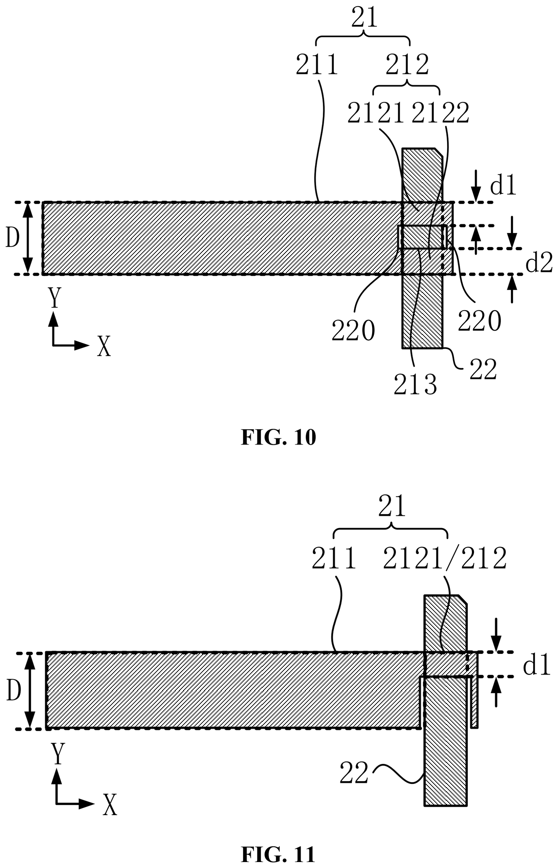

Further, FIG. 10 is a schematic structural diagram of a first section and a second section according to an embodiment of the present disclosure. As shown in FIG. 7 to FIG. 10, the first section 21 is divided into the first segment 211 and the second segment 212 that are arranged in the first direction X. In the direction perpendicular to the plane where the base substrate is located, the first segment 211 does not overlap with the second section 22, the second segment 212 overlaps the second section 22, or in the direction perpendicular to the plane where the base substrate is located, a portion in which the first section 21 does not overlap with the second section 22 is the first segment 211, and a portion in which the first section 21 overlaps the second section 22 is the second segment 212.

The area per unit length of the second segment 212 is less than the area per unit length of the first segment 211 in the first direction X, so that within the same length in the first direction X, an area of an overlapping portion of the first section 21 and the second section 22 is less than an area of a non-overlapping portion of the first section 21 and the second section 22, to reduce an area per unit length of the second segment 212 in the first direction X, whereby an overlapping area between the first section 21 of the first electrode M31 and the second section 22 of the second electrode M32 is reduced in the direction perpendicular to the plane where the base substrate is located; however, the overlapping area is smaller, a parasitic capacitance formed between the first electrode M31 and the second electrode M32 is smaller, whereby a parasitic capacitance formed between the first electrode M31 of the first drive transistor M3 and the second electrode M32 of the first drive transistor M3 is reduced, and thus the unnecessary coupling power consumption is reduced. Moreover, the mutual interference of voltages between the first electrode M31 and the second electrode M32 can be further reduced, thereby helping to achieve the accurate control of the working state of the first drive transistor M3, reducing the control difficulty of the pixel driving circuit 11, and further facilitating improving the driving capability of the pixel driving circuit 11.

It is to be noted that, in FIG. 7 to FIG. 10, an example in which the first direction X is perpendicular to the second direction Y is used for illustration. In actual application, an included angle between the first direction X and the second direction Y may be set according to actual requirements, and only it needs to be ensured that the first direction X intersects with the second direction Y, which is not limited in the embodiments of the present disclosure.

Moreover, in FIG. 7 to FIG. 9, only an example in which the first drive transistor M3 is the amplitude drive transistor PAM_M3 is used for illustration. It is to be understood that the first drive transistor M3 is not limited to the amplitude drive transistor PAM_M3 in the above-described pixel driving circuit 11. For example, as previously described, the first drive transistor M3 may also be the pulse width drive transistor PWM_M3. When the pixel driving circuit 11 uses other circuit structures, the first drive transistor M3 may also be a drive transistor in a corresponding circuit structure, which is not limited in the embodiments of the present disclosure.

In conclusion, according to the display panel provided in the embodiments of the present disclosure, the pixel driving circuit includes the first drive transistor, the first electrode of the first drive transistor includes the first section extending in the first direction, the second electrode of the first drive transistor includes the second section extending in the second direction, the first direction intersects with the second direction, the first section includes the first segment and the second segment arranged in the first direction, and the vertical projection of the second segment on the base substrate overlaps the vertical projection of the second section on the base substrate, the area per unit length of the second segment is less than the area per unit length of the first segment in the first direction, so that within the same length in the first direction, an area of an overlapping portion of the first section and the second section is less than an area of an non-overlapping portion of the first section and the second section, to reduce an area per unit length of the second segment in the first direction, whereby an overlapping area between the first section of the first electrode and the second section of the second electrode is reduced in the direction perpendicular to the plane where the base substrate is located, further the parasitic capacitance formed between the first electrode of the first drive transistor and the second electrode of the first drive transistor is reduced, and the unnecessary coupling power consumption is reduced. Moreover, the mutual interference of voltages between the first electrode and the second electrode can be reduced, thereby helping to achieve the accurate control of the working state of the first drive transistor, reducing the control difficulty of the pixel driving circuit, and further improving the driving capability of the pixel driving circuit.

With continued reference to FIG. 7 to FIG. 10, in one or more embodiments, the first electrode M31 is the gate, and the second electrode M32 is the source or the drain.

In one or more embodiments, as shown in FIG. 7 to FIG. 10, the first electrode M31 is a gate of the first drive transistor M3, and the second electrode M32 is a source or a drain of the first drive transistor M3. In this embodiment, the gate of the first drive transistor M3 includes the first section 21, an extension direction of the first section 21 is the first direction X, the source or the drain of the first drive transistor M3 includes the second section 22, and an extension direction of the second section 22 is the second direction Y. The first section 21 in the gate of the first drive transistor M3 is divided into the first segment 211 and the second segment 212 arranged in the first direction X. In the direction perpendicular to the plane where the base substrate is located, the first segment 211 does not overlap with the second section 22, and the second segment 212 overlaps the second section 22.

In this embodiment, the area per unit length of the second segment 212 in the first direction X can be reduced in the gate of the first drive transistor M3, so that the parasitic capacitance formed between the gate of the first drive transistor M3 and the source or the drain of the first drive transistor M3 can be reduced, thereby reducing the unnecessary coupling power consumption. Moreover, the mutual interference of voltages between the gate of the first drive transistor M3 and the source or the drain of the first drive transistor M3 can be reduced, thereby helping to achieve the accurate control of the working state of the first drive transistor M3, reducing the control difficulty of the pixel driving circuit 11, and further facilitating improving the driving capability of the pixel driving circuit 11.

Moreover, in this embodiment, the structures of the source of the first drive transistor M3 and the drain of the first drive transistor M3 may not be changed, to ensure that the source of the first drive transistor M3 and the drain of the first drive transistor M3 have a sufficient setting area, and to ensure that the source of the first drive transistor M3 and the drain of the first drive transistor M3 have a relatively small resistor. When the first drive transistor M3 works, the first drive transistor M3 may output a relatively large current, thereby improving the output capability of the first drive transistor M3.

It is to be noted that in other embodiments, the first electrode M31 is disposed to be the source or the drain, and the second electrode M32 is disposed to be the gate. With the arrangement, a second segment 212 that overlaps the gate may be disposed in the source or drain of the first drive transistor M3, and an area per unit length of the second segment 212 in the first direction X is reduced, so that the parasitic capacitance formed between the gate of the first drive transistor M3 and the source or the drain of the first drive transistor M3 is reduced, thereby improving the driving capability of the pixel driving circuit 11, which is not limited in the embodiments of the present disclosure.

FIG. 11 is another schematic structural diagram of a first section and a second section according to an embodiment of the present disclosure. As shown in FIG. 11, in one or more embodiments, the second segment 212 includes a first connection portion 2121 connected to the first segment 211. A length of the first connection portion 2121 in the second direction Y is d1, and a length of the first segment 211 in the second direction Y is D, where d1 < D.

In one or more embodiments, as shown in FIG. 11, the first connection portion 2121 of the second section 22 is connected to the adjacent first segment 211 in the first direction X, to ensure the conductivity of the first section 21.

A length d1 of the first connection portion 2121 in the second direction Y is less than a length D of the first segment 211 in the second direction Y, to reduce a length of the second segment 212 in the second direction Y, whereby a notch overlapping with the second section 22 is formed on the first section 21 in the direction perpendicular to the plane where the base substrate is located. With the arrangement, in the first direction X, the area per unit length of the second segment 212 is less than the area per unit length of the first segment 211 , so that the overlapping area between the first section 21 of the first electrode M31 and the second section 22 of the second electrode M32 is reduced, and the parasitic capacitance formed between the first electrode M31 of the first drive transistor M3 and the second electrode M32 of the first drive transistor M3 is reduced.

The shape and position of the first connection portion 2121 are not limited in the embodiments of the present disclosure.

For example, as shown in FIG. 11, in the second direction Y, the first connection portion 2121 may be disposed on a side of the first section 21, so that one notch overlapping with the second section 22 is formed on the other side of the first section 21.

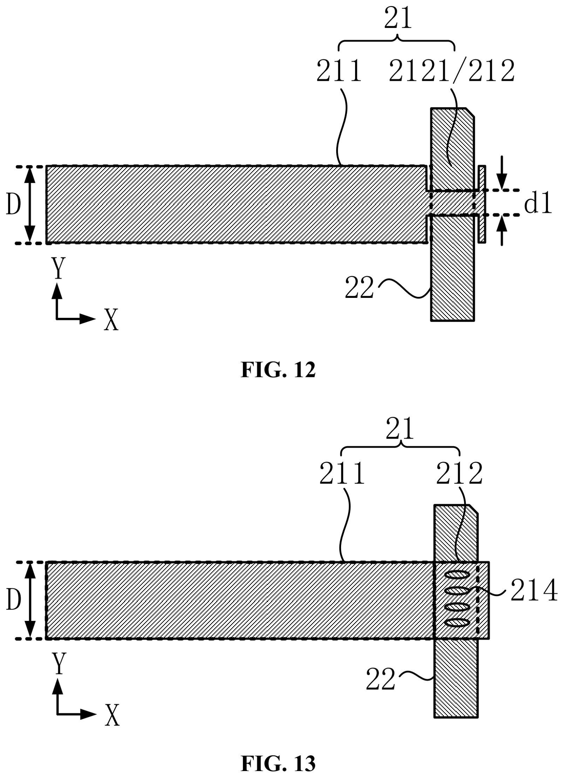

FIG. 12 is yet another schematic structural diagram of a first section and a second section according to an embodiment of the present disclosure. As shown in FIG. 12, in one or more embodiments, in the second direction Y, the first connection portion 2121 may also be disposed in the middle of the first section 21, so that one notch overlapping with the second section 22 is formed on each of two sides of the first section 21.

In the embodiments shown in FIGS. 11 and 12, only one first connection portion 2121 is connected to the first segment 211 adjacent to the one first connection portion 2121, so that in the condition that normal operation of the first drive transistor M3 is ensured, the overlapping area between the first section 21 of the first electrode M31 and the second section 22 of the second electrode M32 can be greatly reduced, and the parasitic capacitance formed between the first electrode M31 of the first drive transistor M3 and the second electrode M32 of the first drive transistor M3 can be reduced.

It is to be noted that a specific value of the length d1 of the first connection portion 2121 in the second direction Y may be set according to actual requirements. It is to be understood that the smaller the length d1 of the first connection portion 2121 in the second direction Y is, the smaller the area per unit length of the second segment 212 in the first direction X is, as a result, the smaller the overlapping area between the first section 21 of the first electrode M31 and the second section 22 of the second electrode M32 is, and thus the smaller the parasitic capacitance formed between the first electrode M31 of the first drive transistor M3 and the second electrode M32 of the first drive transistor M3 is.

In one or more embodiments, d1 ≥ 2.5µm, so that it is conducive to reducing the process difficulty while ensuring that the overlapping area between the first section 21 of the first electrode M31 and the second section 22 of the second electrode M32 is relatively small, thereby avoiding circuit breaking of the first connection portion 2121 due to the process error, and ensuring the conductive performance between the second segment 212 and the first segment 211.

In one or more embodiments, d1 ≤ 5µm, so that it is conducive to greatly reducing the length of the second segment 212 in the second direction Y, reducing the overlapping area between the first section 21 of the first electrode M31 and the second section 22 of the second electrode M32, and reducing the parasitic capacitance formed between the first electrode M31 of the first drive transistor M3 and the second electrode M32 of the first drive transistor M3.

With continued reference to FIG. 10, in one or more embodiments, the second segment 212 further includes a second connection portion 2122 connected to the first segment 211, where a length of the second connection portion 2122 in the second direction Y is d2, where d1 + d2 < D.

In one or more embodiments, as shown in FIG. 10, in the first direction X, the second segment 212 is further disposed with the second connection portion 2122 to connect to the adjacent first segment 211. In this way, the reliability of the second segment 212 is improved while ensuring that the length of the second segment 212 in the second direction Y is reduced and an overlapping area between the first section 21 and the second section 22 is reduced, thereby avoiding the problem of the wire breakage occurring in the first section 21 at the second segment 212.

The second connection portion 2122 and the first connection portion 2121 may be arranged in the second direction Y, and a sum of a length d1 of the first connection portion 2121 in the second direction Y and a length d2 of the second connection portion 2122 in the second direction Y is less than a length D of the first segment 211 in the second direction Y, whereby in the first direction X, the area per unit length of the second segment 212 is ensured to be less than the area per unit length of the first segment 211, the overlapping area between the first section 21 of the first electrode M31 and the second section 22 of the second electrode M32 is reduced, and the parasitic capacitance formed between the first electrode M31 of the first drive transistor M3 and the second electrode M32 of the first drive transistor M3 is reduced.

It is to be noted that the shape and position of the first connection portion 2121 and the second connection portion 2122 are not limited in the embodiments of the present disclosure. Specific values of lengths of the first connection portion 2121 and the second connection portion 2122 in the second direction Y may also be set according to actual requirements. It is to be understood that the smaller the sum of lengths of the first connection portion 2121 and the second connection portion 2122 in the second direction Y is, the smaller the area per unit length of the second segment 212 in the first direction X is, as a result, the smaller the overlapping area between the first section 21 of the first electrode M31 and the second section 22 of the second electrode M32, and thus the smaller the parasitic capacitance formed between the first electrode M31 of the first drive transistor M3 and the second electrode M32 of the first drive transistor M3 is.

In one or more embodiments, d2 ≥ 2.5µm, so that it is conducive to reducing the process difficulty while ensuring that the overlapping area between the first section 21 of the first electrode M31 and the second section 22 of the second electrode M32 is relatively small, thereby avoiding circuit breaking of the second connection portion 2122 due to the process error, and ensuring the conductive performance between the second segment 212 and the first segment 211.

In one or more embodiments, d2 ≤ 5µm, and it is conducive to greatly reducing the length of the second segment 212 in the second direction Y, reducing the overlapping area between the first section 21 of the first electrode M31 and the second section 22 of the second electrode M32, and reducing the parasitic capacitance formed between the first electrode M31 of the first drive transistor M3 and the second electrode M32 of the first drive transistor M3.

With continued reference to FIG. 10, in one or more embodiments, the first connection portion 2121 and the second connection portion 2122 are arranged in the second direction Y, and a first hollow portion 213 is disposed between the first connection portion 2121 and the second connection portion 2122. A vertical projection of the first hollow portion 213 on the base substrate overlaps a vertical projection of the second section 22 on the base substrate.

In one or more embodiments, as shown in FIG. 10, a gap exists between the second connection portion 2122 and the first connection portion 2121 in the second direction Y, so that one first hollow portion 213 overlapping with the second section 22 is formed between the first connection portion 2121 and the second connection portion 2122 in the direction perpendicular to the plane where the base substrate is located. With the arrangement, the area per unit length of the second segment 212 is less than the area per unit length of the first segment 211 in the first direction X, so that the overlapping area between the first section 21 of the first electrode M31 and the second section 22 of the second electrode M32 is reduced, and the parasitic capacitance formed between the first electrode M31 of the first drive transistor M3 and the second electrode M32 of the first drive transistor M3 is reduced.

With continued reference to FIG. 10, in one or more embodiments, the first segment 211 includes a third hollow portion 220 communicating with the first hollow portion 213. In this way, in the first direction X, a distance between the first segment 211 and the second section 22 may be increased in some areas, so that a parasitic capacitance between the first segment 211 and the second section 22 can be reduced, thereby reducing the parasitic capacitance formed between the first electrode M31 of the first drive transistor M3 and the second electrode M32 of the first drive transistor M3.

In the first direction X, the third hollow portion 220 may be located on at least one side of the second section 22. For example, as shown in FIG. 10, in the first direction X, the third hollow portion 220 is located on each of two opposite sides of the second section 22, to further reduce the parasitic capacitance between the first segment 211 and the second section 22, which is in turn conducive to reducing the parasitic capacitance formed between the first electrode M31 of the first drive transistor M3 and the second electrode M32 of the first drive transistor M3, but the embodiments of the present disclosure are not limited thereto.

In other embodiments, in the first direction X, the third hollow portion 220 may also be located only on a side of the second section 22, which is not limited in the embodiments of the present disclosure.

Further, a length of the third hollow portion 220 in the first direction X may be greater than 0 and less than or equal to 3 µm, and in this way, the third hollow portion 220 can be avoided from greatly affecting the electrical conductivity of the first segment 211 while ensuring that the parasitic capacitance between the first segment 211 and the second section 22 is reduced, thereby facilitating ensuring the operating performance of the first drive transistor M3.

FIG. 13 is yet another schematic structural diagram of a first section and a second section according to an embodiment of the present disclosure. As shown in FIG. 13, in one or more embodiments, the length of the second segment 212 in the second direction Y is equal to the length of the first segment 211 in the second direction Y, the second segment 212 includes at least one second hollow portion 214, and a vertical projection of the second hollow portion 214 on the base substrate overlaps a vertical projection of the second section 22 on the base substrate.

In one or more embodiments, as shown in FIG. 13, in the second direction Y, a length of the second segment 212 may be equal to a length of the first segment 211. In the direction perpendicular to the plane where the base substrate is located, the second hollow portion 214 overlapping with the second section 22 is disposed on the second segment 212, to reduce the overlapping area between the first section 21 of the first electrode M31 and the second section 22 of the second electrode M32, and thus reduce the parasitic capacitance formed between the first electrode M31 of the first drive transistor M3 and the second electrode M32 of the first drive transistor M3.

The shape and the number of the second hollow portion 214 may be set according to actual requirements, which is not limited in the embodiments of the present disclosure.

In one or more embodiments, a length of the second hollow portion 214 in the first direction X and a length of the second hollow portion 214 in the second direction Y may both be greater than or equal to 2.5 µm, so that it is conducive to reducing the process difficulty while ensuring that the overlapping area between the first section 21 of the first electrode M31 and the second section 22 of the second electrode M32 is significantly reduced, thereby avoiding that the second segment 212 cannot form effective apertures at the position of the second hollow portion 214 due to the process error.

With continued reference to FIG. 13, in one or more embodiments, the length of the second hollow portion 214 in the first direction X is less than or equal to a length of the second section 22 in the first direction X, and in this way, the occupied space of the second hollow portion 214 is reduced while ensuring that the parasitic capacitance between the second segment 212 and the second section 22 is reduced, thereby facilitating reducing the negative effect of the third hollow portion 220 on the conductive performance of the second segment 212.

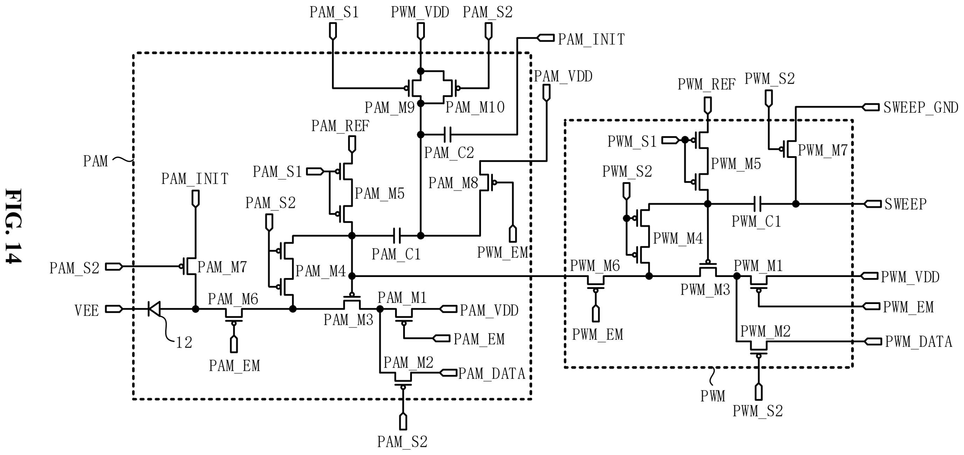

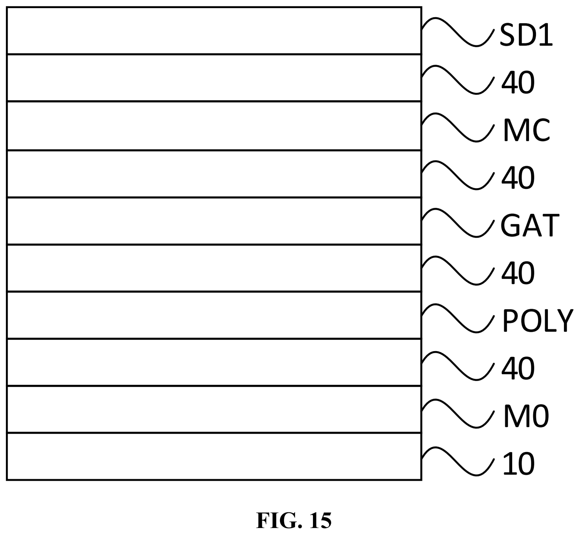

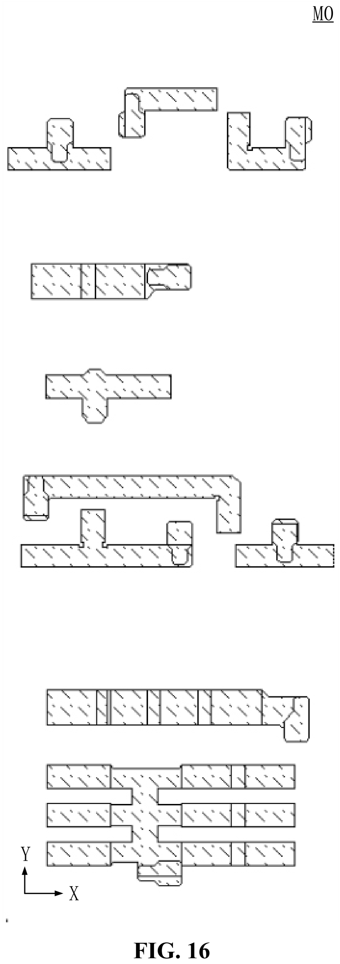

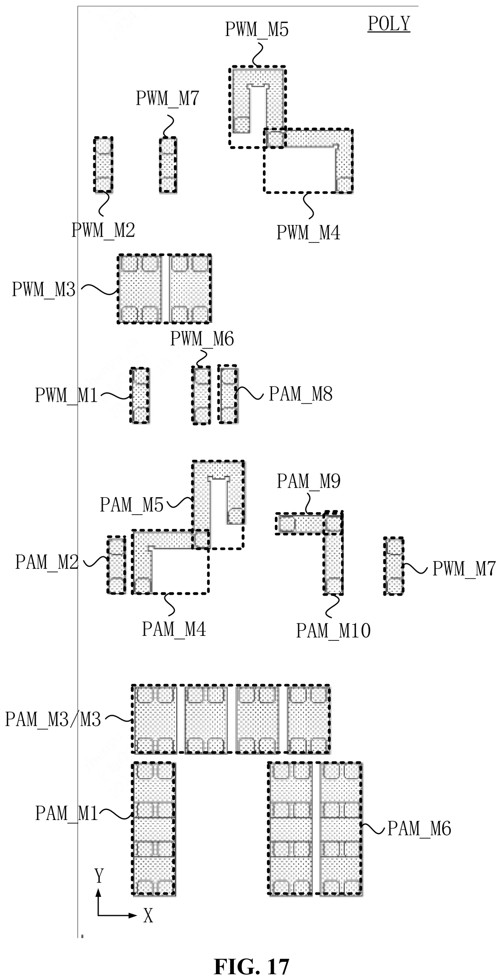

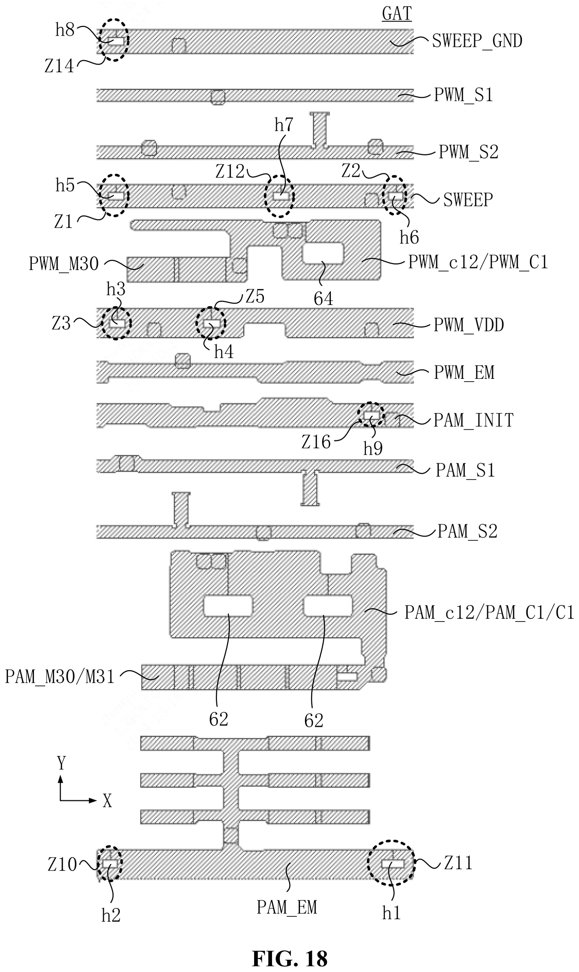

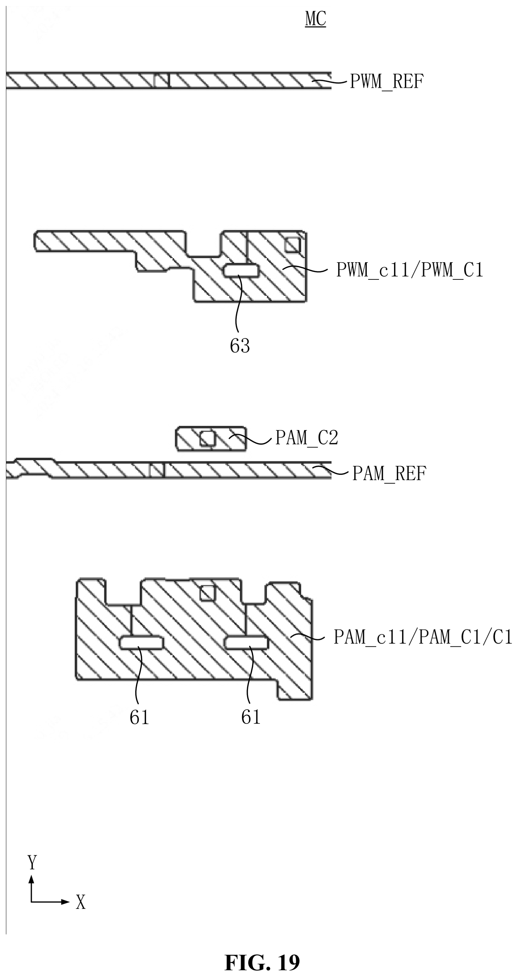

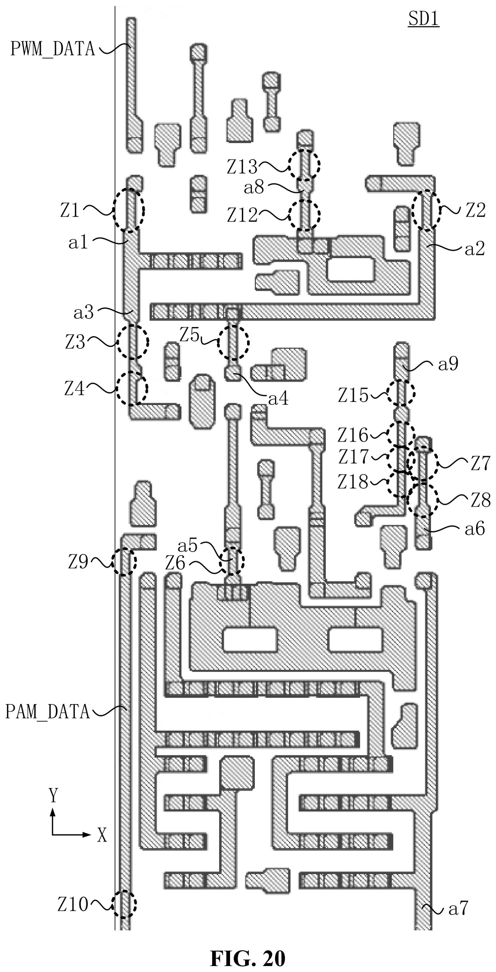

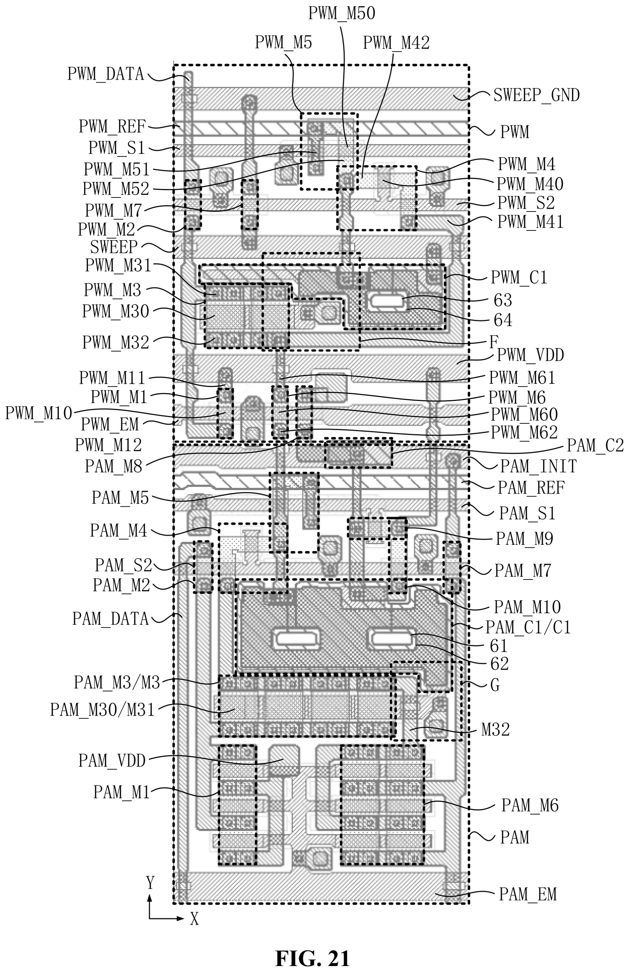

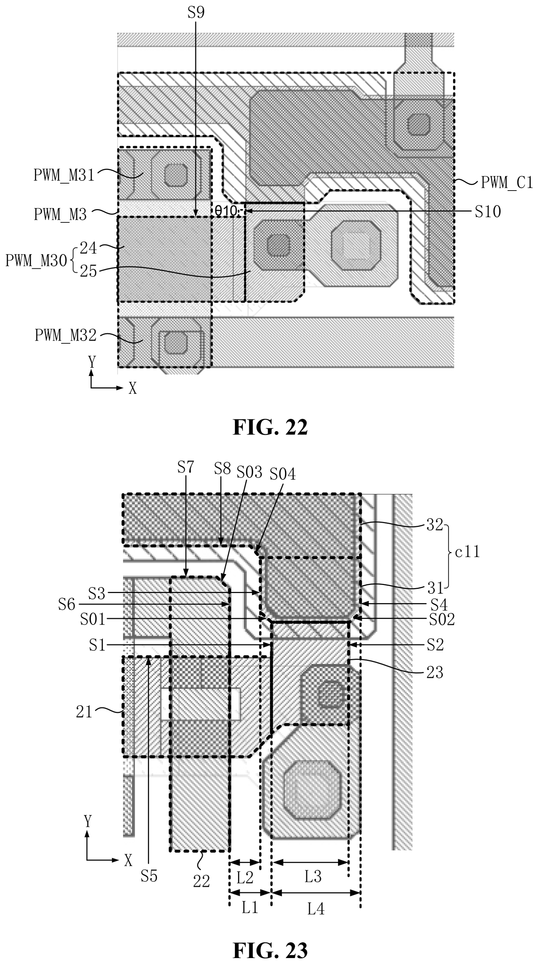

FIG. 14 is another schematic structural diagram of a pixel driving circuit according to an embodiment of the present disclosure, FIG. 15 is a schematic diagram showing a film layer structure of a display panel according to an embodiment of the present disclosure, FIG. 16 is a schematic structural diagram of a first metal layer in the display panel shown in FIG. 15, FIG. 17 is a schematic structural diagram of a semiconductor layer in the display panel shown in FIG. 15, FIG. 18 is a schematic structural diagram of a second metal layer in the display panel shown in FIG. 15, FIG. 19 is a schematic structural diagram of a third metal layer in the display panel shown in FIG. 15, FIG. 20 is a schematic structural diagram of a fourth metal layer in the display panel shown in FIG. 15, FIG. 21 is a schematic diagram showing a laminated structure of all film layers from a first metal layer to a fourth metal layer in the display panel shown in FIG. 15, FIG. 22 is an enlarged schematic structural diagram at a position F of FIG. 21, and FIG. 23 is an enlarged schematic structural diagram at a position G of FIG. 21.

In one or more embodiments, FIG. 14 exemplarily shows a circuit structure of a 17T3C (that is, including 17 transistors and 3 capacitors), and the film layer structure shown in FIGS. 15 to FIG. 23 may correspond to the pixel driving circuit 11 shown in FIG. 14. As shown in FIG. 15, an example in which the transistors in the pixel driving circuit 11 are all low-temperature poly-silicon (LTPS) transistors is used for illustration, a first metal layer M0, a semiconductor layer POLY, a second metal layer GAT, a third metal layer MC, and a fourth metal layer SD1 are disposed on a side of the base substrate 10 in a laminated manner, and an insulating layer 40 may be disposed between any two adjacent conductive film layers to avoid the occurrence of the short circuit between the two adjacent conductive film layers, but the embodiments of the present disclosure are not limited thereto.

As shown in FIGS. 21 and 23, in one or more embodiments, the pixel driving circuit 11 further includes a first capacitor C1, and the first capacitor C1 includes a first plate c11. The first electrode M31 further includes a third section 23 extending in the second direction Y, the first section 21 is connected to the third section 23, and the second section 22 and the third section 23 are arranged in the first direction X. The first plate c11 includes a first connection section 31 connected to the third section 23, and the third section 23 and the first connection section 31 are arranged in the second direction Y. In the first direction X, a spacing L1 between the third section 23 and the second section 22 is greater than a spacing L2 between the first connection section 31 and the second section 22.

In one or more embodiments, as shown in FIGS. 3 and 14, the amplitude adjustment module PAM may include an amplitude storage capacitor PAM_C1, the amplitude storage capacitor PAM_C1 is connected in series between a second power line PAM_VDD and the amplitude drive transistor PAM_M3, and the second power line PAM_VDD is configured to provide a second power voltage. The amplitude storage capacitor PAM_C1 may be configured to receive an amplitude data signal written to a gate of the amplitude drive transistor PAM_M3 and to maintain a potential of the gate of the amplitude drive transistor PAM_M3 to enable the amplitude drive transistor PAM_M3 to continuously provide the constant drive current.

With continued reference to FIGS. 3 and 14, the pulse width adjustment module PWM may include a pulse width storage capacitor PWM_C1. The pulse width storage capacitor PWM_C1 is connected in series between a sweep signal line SWEEP and a gate of the pulse width drive transistor PWM_M3. The sweep signal line SWEEP is configured to provide a sweep signal. The sweep signal may be in the form of a triangular waveform, for example, the sweep signal may decrease linearly from a high level to a low level, or the sweep signal may increase linearly from a low level to a high level. The pulse width storage capacitor PWM_C1 is configured to receive a pulse width data signal written to the gate of the pulse width drive transistor PWM_M3 and to maintain a potential of the gate of the pulse width drive transistor PWM_M3.

In this embodiment, at least one of the amplitude storage capacitor PAM_C1 or the pulse width storage capacitor PWM_C1 may serve as the first capacitor C1, that is, the first capacitor C1 may be the amplitude storage capacitor PAM_C1, or the first capacitor C1 may be the pulse width storage capacitor PWM_C1, or the first capacitor C1 may include both the amplitude storage capacitor PAM_C1 and the pulse width storage capacitor PWM_C1, which is not limited in the embodiments of the present disclosure.

A first plate c11 of the first capacitor C1 is electrically connected to the first electrode M31 of the first drive transistor M3. In an example, when the first drive transistor M3 is the amplitude drive transistor PAM_M3, the first capacitor C1 may be the amplitude storage capacitor PAM _C1, in this case, the first plate c11 of the first capacitor C1 is connected to the gate of the amplitude drive transistor PAM_M3 (i.e., the first electrode M31 of the first drive transistor M3); and when the first drive transistor M3 is the pulse width drive transistor PWM_M3, the first capacitor C1 may be the pulse width storage capacitor PWM_C1, and in this case, the first plate c11 of the first capacitor C1 is connected to the gate of the pulse width drive transistor PWM_M3 (i.e., the first electrode M31 of the first drive transistor M3).

Further, as shown in FIGS. 21 and 23, an example in which the first drive transistor M3 is the amplitude drive transistor PAM_M3 and the first capacitor C1 is the amplitude storage capacitor PAM_C1 is used for illustration. The first plate c11 of the first capacitor C1 includes a main body section 32. The main body section 32 and the first drive transistor M3 are arranged in the second direction Y. The first connection section 31 connected to the main body section 32 is disposed on the first plate c11, and the third section 23 connected to the first section 21 is disposed on the first electrode M31. An extension direction of the third section 23 is the second direction Y, and the third section 23 and the first connection section 31 are arranged in the second direction Y, to enable the formation of an electrical connection between the third section 23 and the first connection section 31 thereby achieving the electrical connection between the first plate c11 of the first capacitor C1 and the first electrode M31 of the first drive transistor M3.

As shown in FIGS. 21 and 23, the second section 22 and the third section 23 are arranged in the first direction X to avoid the second section 22 and the third section 23 from forming an overlapping in the direction perpendicular to the plane where the base substrate is located, thereby facilitating reducing an overlapping area between the first electrode M31 of the first drive transistor M3 and the second electrode M32 of the first drive transistor M3, and reducing the parasitic capacitance formed between the first electrode M31 and the second electrode M32.

Further, as shown in FIGS. 21 and 23, in the first direction X, the spacing L1 between the third section 23 and the second section 22 is set to be greater than the spacing L2 between the first connection section 31 and the second section 22, to increase a spacing between the third section 23 of the first electrode M31 and the second section 22 of the second electrode M32 in the first direction X, thereby reducing a parasitic capacitance between the first electrode M31 of the first drive transistor M3 and the second electrode M32 of the first drive transistor M3 and reducing the unnecessary coupling power consumption. Moreover, the mutual interference of the voltages between the first electrode M31 of the first drive transistor M3 and the second electrode M32 of the first drive transistor M3 can also be reduced, thereby helping to achieve the accurate control of the working state of the first drive transistor M3, reducing the control difficulty of the pixel driving circuit 11, and further facilitating improving the driving capability of the pixel driving circuit 11.

The spacing L1 between the third section 23 and the second section 22 may be set to be greater than or equal to 1 µm to ensure that the parasitic capacitance between the first electrode M31 of the first drive transistor M3 and the second electrode M32 of the first drive transistor M3 is relatively small. Further, the spacing L1 between the third section 23 and the second section 22 may be set to be greater than or equal to 2.5 µm, to ensure that the parasitic capacitance between the first electrode M31 and the second electrode M32 remains at the low level under the condition of the existence of the process error, which is not limited in the embodiments of the present disclosure.

It is to be noted that in FIGS. 21 and 23, only an example in which the first capacitor C1 is the amplitude storage capacitor PAM_C1 is used for illustration. It is to be understood that the first capacitor C1 is not limited to the amplitude storage capacitor PAM_C1 in the pixel driving circuit 11 described above. For example, as previously described, the first capacitor C1 may also be the pulse width storage capacitor PWM_C1, and when the pixel driving circuit 11 adopts other circuit structures, the first capacitor C1 may also be the storage capacitor in a corresponding circuit structure, which is not limited in the embodiments of the present disclosure.

With continued reference to FIGS. 21 and 23, in one or more embodiments, a length L3 of the third section 23 in the first direction X is less than a length L4 of the first connection section 31 in the first direction X.

In one or more embodiments, as shown in FIGS. 21 and 23, in the first direction X, the length L3 of the third section 23 is set to be less than the length L4 of the first connection section 31, to reduce the length L3 of the third section 23 in the first direction X. In this way, the spacing between the third section 23 and the second section 22 may be increased, so that it is conducive to increasing the spacing between the third section 23 and other signal lines or nodes in the first direction X while achieving the smaller parasitic capacitance between the first electrode M31 of the first drive transistor M3 and the second electrode M32 of the first drive transistor M3, thereby reducing the signal interference between the first electrode M31 of the first drive transistor M3 and other signal lines or nodes, achieving the accurate control of the working state of the first drive transistor, and reducing the control difficulty of the pixel driving circuit, which in turn is conducive to improving the driving capability of the pixel driving circuit.

In one or more embodiments, the length L3 of the third section 23 in the first direction X is greater than or equal to 1.2 µm, to ensure the electrical conductivity between the first section 21 and the first connection section 31.

Further, the length L3 of the third section 23 in the first direction X may be set to be greater than or equal to 2.5 µm, which is conducive to reducing the process difficulty and avoiding circuit breaking of the third section 23 due to the process error.

With continued reference to FIGS. 21 and 23, in one or more embodiments, a boundary of the third section 23 on a side close to the second section 22 is a first boundary S1, and a boundary of the third section 23 on a side away from the second section 22 is a second boundary S2. A boundary of the first connection section 31 on a side close to the second section 22 is a third boundary S3, and a boundary of the first connection section 31 on a side away from the second section 22 is a fourth boundary S4. In the first direction X, the first boundary S1 is located on a side of the third boundary S3 away from the second section 22, and the second boundary S2 is located on a side of the fourth boundary S4 close to the second section 22.

In one or more embodiments, as shown in FIGS. 21 and 23, in the first direction X, a first boundary S1 located on a left side of the third section 23 is located on a side of a third boundary S3 which is located on a left side of the first connection section 31, away from the second section 22, so that a spacing L1 between the first boundary S1 of the third section 23 and the second section 22 is greater than the spacing L2 between the third boundary S3 of the first connection section 31 and the second section 22, thereby increasing the spacing between the third section 23 of the first electrode M31 and the second section 22 of the second electrode M32 in the first direction X, and further achieving the reduction of the parasitic capacitance between the first electrode M31 of the first drive transistor M3 and the second electrode M32 of the first drive transistor M3.

Further, in the first direction X, a second boundary S2 on a right side of the third section 23 is located on a side of the fourth boundary S4 which is located on a right side of the first connection section 31, close to the second section 22, so that the length L3 of the third section 23 in the first direction X can be further reduced. In this way, the spacing between the third section 23 and other signal lines or nodes in the first direction X may be increased, thereby reducing the signal interference between the first electrode M31 of the first drive transistor M3 and other signal lines or nodes, achieving the accurate control of the working state of the first drive transistor, and reducing the control difficulty of the pixel driving circuit, which in turn is conducive to improving the driving capability of the pixel driving circuit.

In the first direction X, a distance between the first boundary S1 and the third boundary S3 may be greater than or equal to 0.1 µm, to ensure that the spacing L1 between the first boundary S1 of the third section 23 and the second section 22 may be greater than the spacing L2 between the third boundary S3 of the first connection section 31 and the second section 22 under the condition of the existence of the process error, so that in the first direction X, the spacing between the third section 23 of the first electrode M31 and the second section 22 of the second electrode M32 is increased, and the parasitic capacitance between the first electrode M31 of the first drive transistor M3 and the second electrode M32 of the first drive transistor M3 is reduced.

Further, in the first direction X, the distance between the first boundary S1 and the third boundary S3 may be less than or equal to 5 µm, to avoid circuit breaking due to the length L3 of the third section 23 in the first direction X being too small.

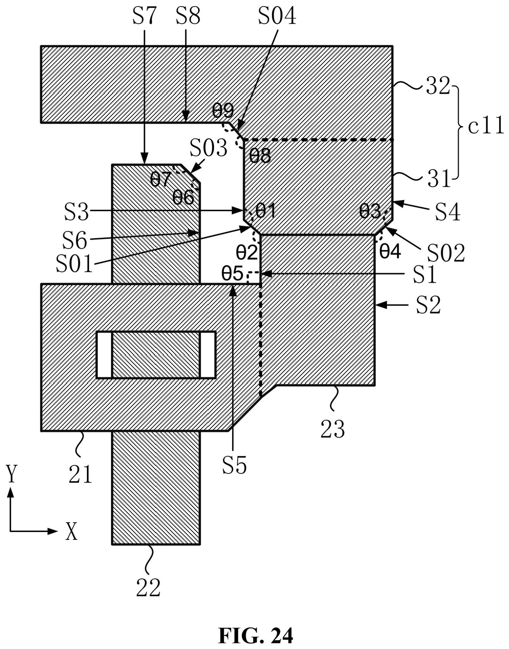

FIG. 24 is a schematic structural diagram of a third section and a first connection section according to an embodiment of the present disclosure. As shown in FIGS. 21, 23 and 24, in one or more embodiments, a boundary of the third section 23 on a side close to the second section 22 is a first boundary S1, and the first boundary S1 extends in the second direction Y. A boundary of the first connection section 31 on a side close to the second section 22 is a third boundary S3, and the third boundary S3 extends in the second direction Y. The first connection section 31 further includes a first chamfered boundary S01, and the first chamfered boundary S01 is connected to the third boundary S3 and the first boundary S1. An included angle θ1 between the first chamfered boundary S01 and the third boundary S3 is an obtuse angle, and an included angle θ2 between the first chamfered boundary S01 and the first boundary S1 is an obtuse angle.

In one or more embodiments, as shown in FIGS. 21, 23 and 24, a first boundary S1 on a left side of the third section 23 and a third boundary S3 on a left side of the first connection section 31 are connected through the first chamfered boundary S01. An included angle θ1 between the first chamfered boundary S01 and the third boundary S3 is greater than 90°, and an included angle θ2 between the first chamfered boundary S01 and the first boundary S1 is greater than 90°, so that the first boundary S1 and the third boundary S3 are connected through a chamfer, and in this way, an edge, located between the first boundary S1 and the third boundary S3, of the first connection section 31 is smoother, thereby avoiding that an electric field is concentrated at this position, preventing the generation of tip-end static electricity, reducing the risk of electrostatic discharge, and improving the reliability and the stability of the pixel driving circuit 11.

The first chamfered boundary S01 may be a straight line, which is simple in design and is easy to implement. In other embodiments, the first chamfer boundary S01 may also be a curved line, so that a smoother transition between the first boundary S1 and the third boundary S3 is provided, the concentration of the electric field is reduced, and the tip-end static electricity is further prevented, which is not limited in the embodiments of the present disclosure.

It is to be noted that, in this embodiment, a length of the first chamfered boundary S01 in the first direction X may be set to be less than or equal to half of the length of the first connection section 31 in the first direction X, to ensure that the third section 23 has a sufficient length in the first direction X and to ensure the electrical connection performance between the third section 23 and the first connection section 31.

With continued reference to FIGS. 21, 23 and 24, in one or more embodiments, the second boundary S2 extends in the second direction Y, and the fourth boundary S4 extends in the second direction Y. The first connection section 31 further includes a second chamfered boundary S02, the second chamfered boundary S02 is connected to the fourth boundary S4 and the second boundary S2. An included angle θ3 between the second chamfered boundary S02 and the fourth boundary S4 is an obtuse angle, and an included angle θ4 between the second chamfered boundary S02 and the second boundary S2 is an obtuse angle.

In one or more embodiments, as shown in FIGS. 21, 23 and 24, a second boundary S2 on a right side of the third section 23 and a fourth boundary S4 on a right side of the first connection section 31 are connected through the second chamfered boundary S02, where the included angle θ3 between the second chamfered boundary S02 and the fourth boundary S4 is greater than 90°, and the included angle θ4 between the second chamfered boundary S02 and the second boundary S2 is greater than 90°, so that the second boundary S2 and the fourth boundary S4 are connected through a chamfer, whereby an edge, located between the second boundary S2 and the fourth boundary S4, of the first connection section 31 is smoother, thereby avoiding that the electric field is concentrated at this position, preventing the generation of tip-end static electricity, reducing the risk of electrostatic discharge, and improving the reliability and the stability of the pixel driving circuit 11.

The second chamfered boundary S02 may be a straight line, which is simple in design and is easy to implement. In other embodiments, the second chamfer boundary S02 may also be a curved line, so that a smoother transition between the second boundary S2 and the fourth boundary S4 is provided, the concentration of the electric field is reduced, and the tip-end static electricity is further prevented, which is not limited in the embodiments of the present disclosure.

It is to be noted that, in this embodiment, a length of the second chamfered boundary S02 in the first direction X may be set to be less than or equal to half of the length of the first connection section 31 in the first direction X, to ensure that the third section 23 has a sufficient length in the first direction X and to ensure the electrical connection performance between the third section 23 and the first connection section 31.

With continued reference to FIGS. 21, 23 and 24, in one or more embodiments, the pixel driving circuit 11 further includes a first capacitor C1, and the first capacitor C1 includes a first plate c11. The first electrode M31 further includes a third section 23 extending in the second direction Y, the first section 21 is connected to the third section 23, and the second section 22 and the third section 23 are arranged in the first direction X. A boundary of the first section 21 on a side close to the first capacitor C1 is a fifth boundary S5, and the fifth boundary S5 extends in the first direction X. The boundary of the third section 23 on a side close to the second section 22 is the first boundary S1, and the first boundary S1 extends in the second direction Y. The fifth boundary S5 is contiguous with the first boundary S1.

The structure of the first capacitor C1 and the connection relationship among the first capacitor C1 and other components may be referred to the above embodiment, and the details are not repeated herein.

In this embodiment, as shown in FIGS. 21, 23 and 24, in the second direction Y, the fifth boundary S5 of the first section 21 on a side close to the first capacitor C1 extends in the first direction X. In the first direction X, the first boundary S1 of the third section 23 on a side close to the second section 22 extends in the second direction Y. The fifth boundary S5 is contiguous with the first boundary S1, that is, the fifth boundary S5 is directly connected to the first boundary S1, and no gap or other boundaries exist between the fifth boundary S5 and the first boundary S1. Moreover, no chamfer design is adopted between the fifth boundary S5 and the first boundary S1, so that the spacing between an abutment position of the fifth boundary S5 as well as the first boundary S1 and the second section 22 can be increased, thereby reducing the parasitic capacitance between the first electrode M31 of the first drive transistor M3 and the second electrode M32 of the first drive transistor M3, and reducing the unnecessary coupling power consumption. Moreover, the mutual interference of the voltages between the first electrode M31 of the first drive transistor M3 and the second electrode M32 of the first drive transistor M3 can also be reduced, thereby helping to achieve the accurate control of the working state of the first drive transistor M3, reducing the control difficulty of the pixel driving circuit 11, and further facilitating improving the driving capability of the pixel driving circuit 11.

In an example, as shown in FIGS. 21, 23, and 24, when the first direction X is perpendicular to the second direction Y, an included angle 05 between the fifth boundary S5 and the first boundary S1 may be a right angle, that is, θ5 = 90°, so that it is conducive to making the layout of the pixel driving circuit 11 more compact while increasing the effective spacing between a junction between the first section 21 as well as the third section 23 and the second section 22 and reducing the parasitic capacitance between the first electrode M31 of the first drive transistor M3 and the second electrode M32 of the first drive transistor M3, thereby saving the space, which is not limited in the embodiments of the present disclosure.

With continued reference to FIGS. 21, 23 and 24, in one or more embodiments, the pixel driving circuit 11 further includes a first capacitor C1, and the first capacitor C1 includes a first plate c11. In the first direction X, a boundary of the second section 22 on a side close to the first plate c11 is a sixth boundary S6, and the sixth boundary S6 extends in the second direction Y. In the second direction Y, a boundary of the second section 22 on a side close to the first plate c11 is a seventh boundary S7, and the seventh boundary S7 extends in the first direction X. The second section 22 further includes a third chamfered boundary S03, and the third chamfered boundary S03 is connected to the sixth boundary S6 and the seventh boundary S7. An included angle θ6 between the third chamfered boundary S03 and the sixth boundary S6 is an obtuse angle, and an included angle 07 between the third chamfered boundary S03 and the seventh boundary S7 is an obtuse angle.

The structure of the first capacitor C1 and the connection relationship among the first capacitor C1 and other components may be referred to the above embodiments, and the details are not repeated herein.

In this embodiment, as shown in FIGS. 21, 23 and 24, in the first direction X, the sixth boundary S6 of the second section 22 on a side close to the first plate c11 extends in the second direction Y. In the second direction Y, the seventh boundary S7 of the second section 22 on a side close tothe first plate c11 extends in the first direction X. The sixth boundary S6 and the seventh boundary S7 are connected by the third chamfered boundary S03, and the included angle θ6 between the third chamfered boundary S03 and the sixth boundary S6 is greater than 90°, and the included angle θ7 between the third chamfered boundary S03 and the seventh boundary S7 is greater than 90°, so that the sixth boundary S6 and the seventh boundary S7 are connected by a chamfer, and in this way, a spacing between the second section 22 and the first plate c11 is increased at the third chamfered boundary S03, the parasitic capacitance between the second electrode M32 of the first drive transistor M3 and the first plate c11 is reduced, and the mutual interference of voltages between the second electrode M32 of the first drive transistor M3 and the first plate c11 is reduced. Further, since the first plate c11 is electrically connected to the third section 23, a potential on the first plate c11 is the same as a potential on the third section 23, so that the parasitic capacitance between the second electrode M32 of the first drive transistor M3 and the first plate c11 is reduced, the mutual interference of voltages between the second electrode M32 of the first drive transistor M3 and the first electrode M31 of the first drive transistor M3 is also indirectly reduced, thereby helping to achieve the accurate control of the working state of the first drive transistor M3, reducing the control difficulty of the pixel driving circuit 11, and further facilitating improving the driving capability of the pixel driving circuit 11.

The third chamfer boundary S03 may be a straight line, which is simple in design and is easy to implement. In other embodiments, the third chamfered boundary S03 may also be a curved line, so that a smoother transition between the sixth boundary S6 and the seventh boundary S7 is provided, the concentration of the electric field is reduced, and the tip-end static electricity is further prevented, which is not limited in the embodiments of the present disclosure.

It is to be noted that, in this embodiment, a length of the third chamfered boundary S03 in the first direction X may be set to be less than or equal to half of the length of the second section 22 in the first direction X, to ensure that the second section 22 has a sufficient setting area, so that the second section 22 has a smaller resistance, and when the first drive transistor M3 works, the first drive transistor M3 can output a larger current, which is conducive to improving the output capability of the first drive transistor M3.

Moreover, in this embodiment, a spacing between the second section 22 and the first plate c11 in a direction parallel to the plane where the base substrate is located may be set to be greater than or equal to 1 µm, to ensure that the parasitic capacitance between the second electrode M32 of the first drive transistor M3 and the first plate c11 is relatively small. Further, the spacing between the second section 22 and the first plate c11 in the direction parallel to the plane where the base substrate is located may be set to be greater than or equal to 2.5 µm, to ensure that the parasitic capacitance between the second electrode M32 of the first drive transistor M3 and the first plate c11 is still maintained at a low level under the condition of the existence of the process error, which is not limited in the embodiments of the present disclosure.

With continued reference to FIGS. 21, 23 and 24, in one or more embodiments, the first plate c11 includes a main body section 32 and a first connection section 31 connected to each other, and the main body section 32 and the first connection section 31 are arranged in the second direction Y. The second section 22 and the first connection section 31 are arranged in the first direction X, and the second section 22 and the main body section 32 are arranged in the second direction Y. A boundary of the first connection section 31 on a side close to the second section 22 is a third boundary S3, and the third boundary S3 extends in the second direction Y. A boundary of the main body section 32 on a side close to the second section 22 is an eighth boundary S8, and the eighth boundary S8 extends in the first direction X. The first plate c11 further includes a fourth chamfered boundary S04, and the fourth chamfered boundary S04 is connected to the third boundary S3 and the eighth boundary S8. An included angle θ8 between the fourth chamfered boundary S04 and the third boundary S3 is an obtuse angle, and an included angle θ9 between the fourth chamfered boundary S04 and the eighth boundary S8 is an obtuse angle.

In one or more embodiments, as shown in FIGS. 21, 23 and 24, the main body section 32 and the first drive transistor M3 are arranged in the second direction Y, a first connection section 31 connected to the main body section 32 is disposed on the first plate c11, a third section 23 connected to the first section 21 is disposed on the first electrode M31, and the main body section 32, the first connection section 31 and the third section 23 are sequentially arranged in the second direction Y and are electrically connected, thereby achieving the electrical connection between the first plate c11 of the first capacitor C1 and the first electrode M31 of the first drive transistor M3.

The second section 22 and the first connection section 31 are arranged in the first direction X, and the second section 22 and the main body section 32 are arranged in the second direction Y to avoid the second section 22 and the first connection section 31 from forming an overlap in the direction perpendicular to the plane where the base substrate is located, whereby the parasitic capacitance between the second electrode M32 of the first drive transistor M3 and the first plate c11 is reduced, and the mutual interference of voltages between the second electrode M32 of the first drive transistor M3 and the first plate c11 is reduced.

In the first direction X, a third boundary S3 of the first connection section 31 on a side close to the second section 22 extends in the second direction Y. In the second direction Y, an eighth boundary S8 of the main body section 32 on a side close to the second section 22 extends in the first direction X. The third boundary S3 and the eighth boundary S8 are connected through the fourth chamfered boundary S04, an included angle θ8 between the fourth chamfered boundary S04 and the third boundary S3 is greater than 90°, and an included angle θ9 between the fourth chamfered boundary S04 and the eighth boundary S8 is greater than 90°, so that the third boundary S3 and the eighth boundary S8 are connected through a chamfer, thereby reducing the process difficulty, also helping to reduce the defection of a film layer, located at a position of the fourth chamfered boundary S04, of the first plate c11, and improving the quality of the film layer.

The fourth chamfer boundary S04 may be a straight line, which is simple in design and is easy to implement. In other embodiments, the fourth chamfer boundary S04 may also be a curved line, so that a smoother transition between the third boundary S3 and the eighth boundary S8 is provided, the difficulty of the process is reduced, and the quality of the film layer is further improved, which is not limited in the embodiments of the present disclosure.

It is to be noted that, in this embodiment, a length of the fourth chamfered boundary S04 in the first direction X may be set to be less than or equal to half of the length of the first connection section 31 in the first direction X, which is conducive to ensuring that the third section 23 has a sufficient length in the first direction X, and to ensuring the electrical connection performance between the third section 23 and the first plate c11.

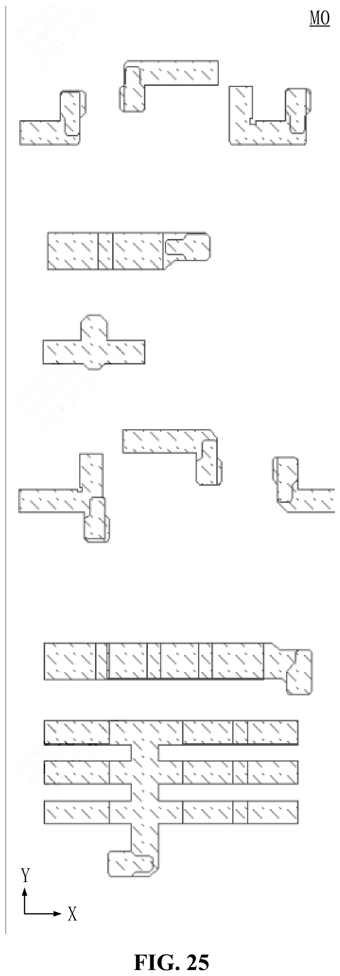

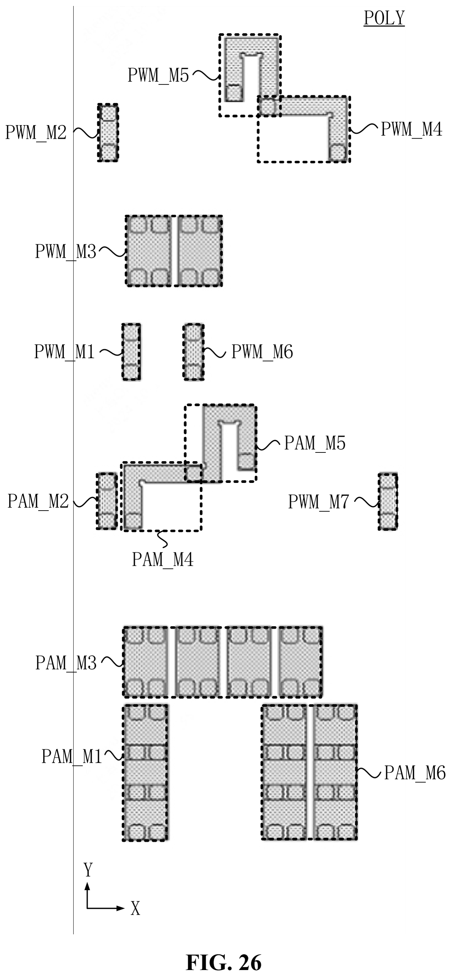

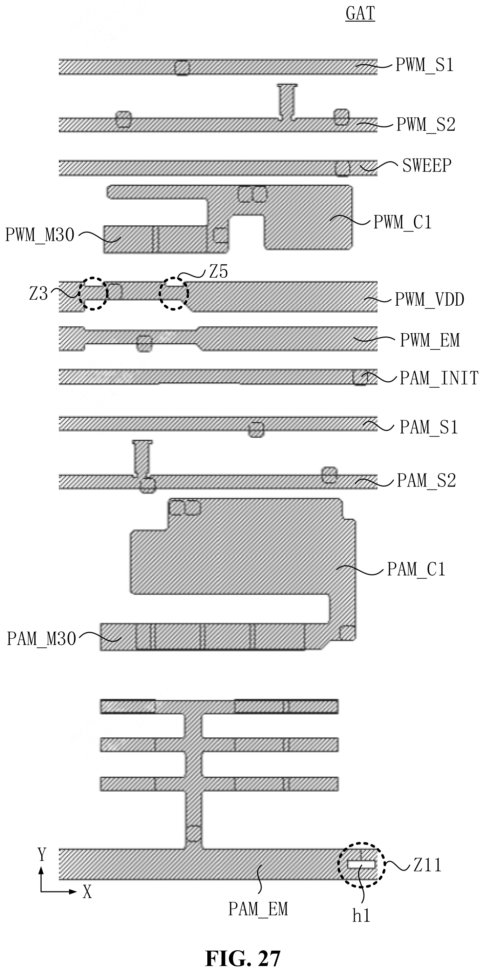

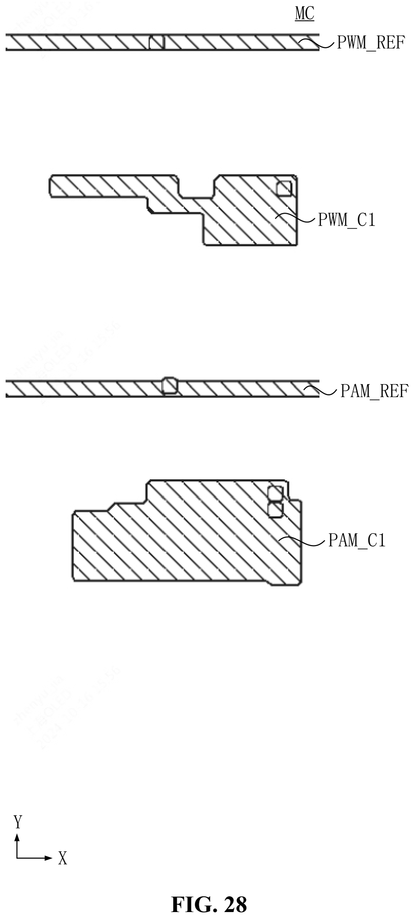

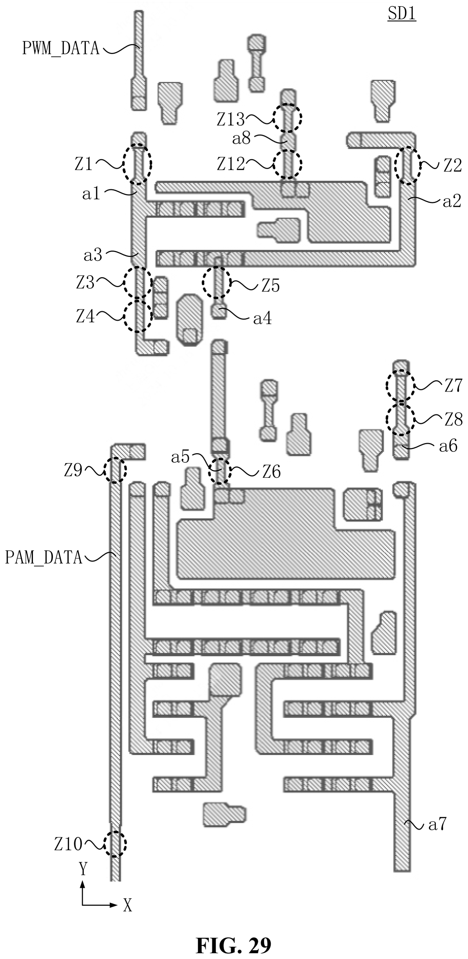

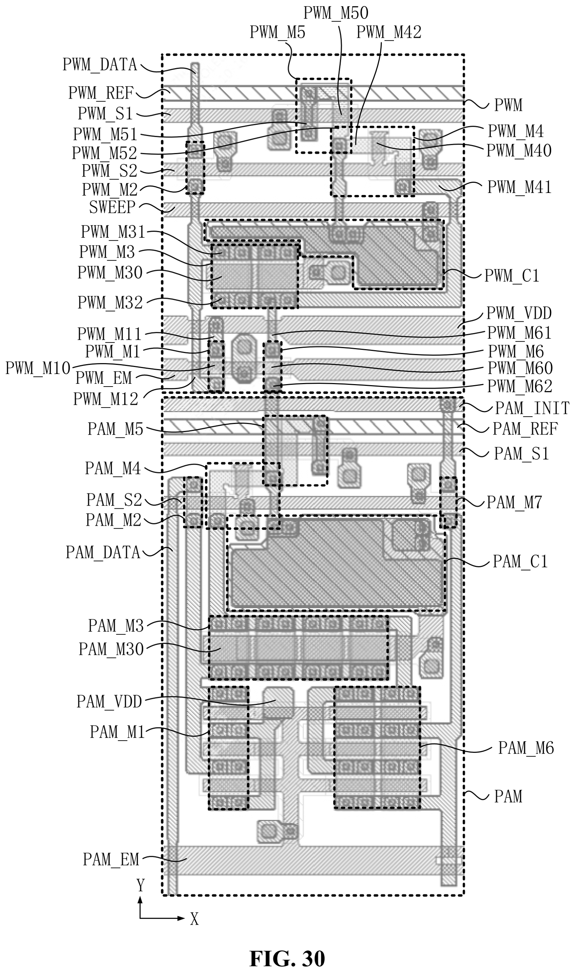

FIG. 25 is another schematic structural diagram of a first metal layer in the display panel shown in FIG. 15, FIG. 26 is another schematic structural diagram of a semiconductor layer in the display panel shown in FIG. 15, FIG. 27 is another schematic structural diagram of a second metal layer in the display panel shown in FIG. 15, FIG. 28 is another schematic structural diagram of a third metal layer in the display panel shown in FIG. 15, FIG. 29 is another schematic structural diagram of a fourth metal layer in the display panel shown in FIG. 15, and FIG. 30 is another schematic diagram showing a laminated structure of all film layers from a first semiconductor layer to an anode layer in the display panel shown in FIG. 15.

The film layer structure shown in FIGS. 25 to FIG. 30 may correspond to the pixel driving circuit 11 shown in FIG. 3.

As shown in FIGS. 7 to FIG. 30, in one or more embodiments, the first drive transistor M3 is the amplitude drive transistor PAM_M3. A spacing between a vertical projection of the gate PWM_M30 of the pulse width drive transistor PWM_M3 on the base substrate and a vertical projection of the first terminal PWM_M31 of the pulse width drive transistor PWM_M3 on the base substrate is greater than 0. A spacing between the vertical projection of the gate of the pulse width drive transistor PWM_M3 on the base substrate and a vertical projection of the second terminal PWM_M32 of the pulse width drive transistor PWM_M3 on the base substrate is greater than 0.

In one or more embodiments, as shown in FIGS. 7 to FIG. 13 and FIGS. 21 to FIG. 24, in the amplitude adjustment module PAM, the amplitude drive transistor PAM_M3 may be set as the first drive transistor M3. An overlapping area between the gate of the amplitude drive transistor PAM_M3 and the source or the drain of the amplitude drive transistor PAM_M3 is reduced, so that the parasitic capacitance formed between the gate of the amplitude drive transistor PAM_M3 and the source or the drain of the amplitude drive transistor PAM_M3 can be reduced to reduce the unnecessary coupling power consumption. Moreover, the mutual interference of voltages between the gate of the amplitude drive transistor PAM_M3 and the source or the drain of the amplitude drive transistor PAM_M3 can also be reduced, thereby helping to achieve the accurate control of the working state of the amplitude drive transistor PAM_M3, reducing the control difficulty of the pixel driving circuit 11, and further facilitating improving the driving capability of the pixel driving circuit 11, but the embodiments of the present disclosure are not limited thereto.

Further, as shown in FIGS. 7 to FIG. 30, in the pulse width adjustment module PWM, the first terminal PWM_M31 of the pulse width drive transistor PWM_M3 may be set as the source, and the second terminal PWM_M32 of the pulse width drive transistor PWM_M3 may be set as the drain, or the first terminal PWM_M31 of the pulse width drive transistor PWM_M3 may be set as the drain, and the second terminal PWM_M32 of the pulse width drive transistor PWM_M3 may be set as the source.

In this embodiment, the gate PWM_M30 of the pulse width drive transistor PWM_M3 and the first terminal PWM_M31 of the pulse width drive transistor PWM_M3 do not have an overlapping region in the direction perpendicular to the plane where the base substrate is located, and the gate PWM_M30 of the pulse width drive transistor PWM_M3 and the second terminal PWM_M32 of the pulse width drive transistor PWM_M3 do not have an overlapping region in the direction perpendicular to the plane where the base substrate is located, to reduce the parasitic capacitance between the gate PWM_M30 of the pulse width drive transistor PWM_M3 and the first terminal PWM_M31, reduce the parasitic capacitance between the gate PWM_M30 of the pulse width drive transistor PWM_M3 and the second terminal PWM_M32, and further reduce the unnecessary coupling power consumption. Moreover, the mutual interference of voltages between the gate PWM_M30 of the pulse width drive transistor PWM_M3 and the first terminal PWM_M31 and between the gate PWM_M30 of the pulse width drive transistor PWM_M3 and the second terminal PWM_M32, thereby helping to achieve the accurate control of the working state of the pulse width drive transistor PWM_M3, reducing the control difficulty of the pixel driving circuit 11, and further facilitating improving the driving capability of the pixel driving circuit 11.

With continued reference to FIG. 3, and FIGS. 7 to FIG. 30, in one or more embodiments, the pulse width adjustment module PWM further includes a first pulse width light-emitting control transistor PWM_M1, a second pulse width light-emitting control transistor PWM_M6, and a pulse width storage capacitor PWM_C1. A first terminal PWM_M11 of the first pulse width light-emitting control transistor PWM_M1 is electrically coupled to a first power line PWM_VDD, a second terminal PWM_M12 of the first pulse width light-emitting control transistor PWM_M1 is electrically connected to the first terminal PWM_M31 of the pulse width drive transistor PWM_M3, and a gate PWM_M10 of the first pulse width light-emitting control transistor PWM_M1 is electrically connected to the pulse width light-emitting control signal line PWM_EM. A first terminal PWM_M61 of the second pulse width light-emitting control transistor PWM_M6 is electrically connected to a second terminal PWM_M32 of the pulse width drive transistor PWM_M3, a second terminal PWM_M62 of the second pulse width light-emitting control transistor PWM_M6 is electrically connected to the amplitude adjustment module PAM, and a gate PWM_M60 of the second pulse width light-emitting control transistor PWM_M6 is electrically connected to the pulse width light-emitting control signal line PWM_EM, and the pulse width storage capacitor PWM_C1 is electrically connected to the gate PWM_M30 of the pulse width drive transistor PWM_M3. In the second direction Y, the first pulse width light-emitting control transistor PWM_M1 and the second pulse width light-emitting control transistor PWM_M6 are both located on a side where the second terminal PWM_M32 of the pulse width drive transistor PWM_M3 away from the first terminal PWM_M31 of the pulse width drive transistor PWM_M3. In the first direction X, an arrangement direction of the first pulse width light-emitting control transistor PWM_M1 and the second pulse width light-emitting control transistor PWM_M6 is the same as an arrangement direction of the pulse width drive transistor PWM_M3 and the pulse width storage capacitor PWM_C1.

In one or more embodiments, as shown in FIG. 3 and FIGS. 7 to 30, in the pulse width adjustment module PWM, the first pulse width light-emitting control transistor PWM_M1 is connected in series between the first power line PWM_VDD and the first terminal PWM_M31 of the pulse width drive transistor PWM_M3, and the gate PWM_M10 of the first pulse width light-emitting control transistor PWM_M1 is configured to receive a first pulse width light-emitting control signal provided by the pulse width light-emitting control signal line PWM_EM.

In the pulse width adjustment module PWM, the second pulse width light-emitting control transistor PWM_M6 is connected in series between the second terminal PWM_M32 of the pulse width drive transistor PWM_M3 and the amplitude adjustment module PAM, for example, the second pulse width light-emitting control transistor PWM_M6 is connected in series between the second terminal PWM_M32 of the pulse width drive transistor PWM_M3 and the gate PAM_M30 of the amplitude drive transistor PAM_M3 in the amplitude adjustment module PAM, in this case, the second terminal PWM_M62 of the second pulse width light-emitting control transistor PWM_M6 is electrically connected to the gate PAM_M30 of the amplitude drive transistor PAM_M3. Moreover, the gate PWM_M60 of the second pulse width light-emitting control transistor PWM_M6 is configured to receive the first pulse width light-emitting control signal provided by the pulse width light-emitting control signal line PWM_EM.

Further, under the control of the first pulse width light-emitting control signal, the first pulse width light-emitting control transistor PWM_M1 may be turned on and transmit the first power voltage provided by the first power line PWM_VDD to the first terminal PWM_M31 of the pulse width drive transistor PWM_M3, moreover, the second pulse width light-emitting control transistor PWM_M6 may also be turned on, to enable the second terminal PWM_M32 of the pulse width drive transistor PWM_M3 to be in communication with the amplitude adjustment module PAM, and further enable the first power line PWM_VDD to be in communication with the amplitude adjustment module PAM to transmit the first power voltage provided by the first power line PWM_VDD to the amplitude adjustment module PAM.

When the second terminal PWM_M62 of the second pulse width light-emitting control transistor PWM_M6 is electrically connected to the gate PAM_M30 of the amplitude drive transistor PAM_M3, the second pulse width light-emitting control transistor PWM_M6 is turned on, so that the second terminal PWM_M32 of the pulse width drive transistor PWM_M3 is in communication with the gate PAM_M30 of the amplitude drive transistor PAM_M3, and further the first power line PWM_VDD is in communication with the gate PAM_M30 of the amplitude drive transistor PAM_M3, to transmit the first power voltage provided by the first power line PWM_VDD to the gate PAM_M30 of the amplitude drive transistor PAM_M3, whereby the amplitude drive transistor PAM_M3 may be controlled to be cut off, and a duration of the drive current provided by the amplitude adjustment module PAM is controlled.

Further, the pulse width storage capacitor PWM_C1 may be connected in series between the sweep signal line SWEEP and the gate PWM_M30 of the pulse width drive transistor PWM_M3, and the pulse width storage capacitor PWM_C1 is configured to receive a pulse width data signal written to the gate PWM_M30 of the pulse width drive transistor PWM_M3 and maintain a potential of the gate PWM_M30 of the pulse width drive transistor PWM_M3.

With continued reference to FIGS. 7, 21 and 30, in this embodiment, in the second direction Y, the first pulse width light-emitting control transistor PWM_M1 and the second pulse width light-emitting control transistor PWM_M6 are both located on a lower side of the second terminal PWM_M32 of the pulse width drive transistor PWM_M3, and the first terminal PWM_M31 of the pulse width drive transistor PWM_M3 is located on an upper side of the second terminal PWM_M32 of the pulse width drive transistor PWM_M3. Moreover, in the first direction X, the first pulse width light-emitting control transistor PWM_M1 is located on a left side of the second pulse width light-emitting control transistor PWM_M6, and the pulse width drive transistor PWM_M3 may likewise be located on a left side of the pulse width storage capacitor PWM_C1. With the arrangement, a connection path between the first terminal PWM_M31 of the pulse width drive transistor PWM_M3 and the second terminal PWM_M12 of the first pulse width light-emitting control transistor PWM_M1 may bypass the gate PWM_M30 of the pulse width drive transistor PWM_M3, thereby enabling no overlapping region to be existed between the first terminal PWM _M31 of the pulse width drive transistor PWM_M3 and the gate PWM_M30 of the pulse width drive transistor PWM_M3 in the direction perpendicular to the plane where the base substrate is located, reducing the parasitic capacitance between the first terminal PWM_M31 of the pulse width drive transistor PWM_M3 and the gate PWM_M30 of the pulse width drive transistor PWM_M3, and further reducing the unnecessary coupling power consumption. Moreover, the mutual interference of voltages between the first terminal PWM_M31 of the pulse width drive transistor PWM_M3 and the gate PWM_M30 of the pulse width drive transistor PWM_M3 may also be reduced, thereby helping to achieve the accurate control of the working state of the pulse width drive transistor PWM_M3, reducing the control difficulty of the pixel driving circuit 11, and further facilitating improving the driving capability of the pixel driving circuit 11.

It is to be noted that the arrangement direction of the pulse width drive transistor PWM_M3 and the pulse width storage capacitor PWM_C1 may refer to an arrangement direction of a center of gravity of the pulse width drive transistor PWM_M3 and a center of gravity of the pulse width storage capacitor PWM_C1 in the first direction X, where the center of gravity refers to the mass-weighted average position of all mass points on the film layer structure, i.e., the mass distribution center of the film layer structure.

With continued reference to FIGS. 7, 21 and 30, in one or more embodiments, in order to make the layout of the pixel driving circuit 11 more compact to reduce the size of the pixel driving circuit 11, and an overlapping exists between the pulse width drive transistor PWM_M3 and the pulse width storage capacitor PWM_C1 in the second direction Y, which is not limited thereto and is not limited in the embodiments of the present disclosure.

With continued reference to FIG. 3, FIGS. 7 to FIG. 30, in one or more embodiments, the first power line PWM_VDD extends in the first direction X. In the second direction Y, the first pulse width light-emitting control transistor PWM_M1 and the second pulse width light-emitting control transistor PWM_M6 are both located on a side of the first power line PWM_VDD away from the pulse width drive transistor PWM_M3.

In one or more embodiments, as shown in FIGS. 7, 21 and 30, the second terminal PWM_M62 of the second pulse width light-emitting control transistor PWM_M6 is electrically connected to the gate PAM_M30 of the amplitude drive transistor PAM_M3. In this embodiment, an extension direction of the first power line PWM_VDD is set as the first direction X, and in the second direction Y, the first power line PWM_VDD is located on a side of the second pulse width light-emitting control transistor PWM_M6 away from the amplitude drive transistor PAM_M3, so that the existence of an overlapping region between the first power line PWM_VDD and the gate PAM_M30 of the amplitude drive transistor PAM_M3 in the direction perpendicular to the plane where the base substrate is located can be avoided, the parasitic capacitance between the first power line PWM_VDD and the gate PAM_M30 of the amplitude drive transistor PAM_M3 is reduced, and the first power voltage on the first power line PWM_VDD is avoided from interfering with the potential of the gate PAM_M30 of the amplitude drive transistor PAM_M3, thereby helping to achieve the accurate control of the working state of the amplitude drive transistor PAM_M3, reducing the control difficulty of the pixel driving circuit 11, and further facilitating improving the driving capability of the pixel driving circuit 11.

Moreover, as shown in FIGS. 7, 21 and 30, in the second direction Y, the first pulse width light-emitting control transistor PWM_M1 is also located on a side of the first power line PWM_VDD away from the pulse width drive transistor PWM_M3, so that it facilitates the formation of an electrical connection between the first pulse width light-emitting control transistor PWM_M1 as well as the second pulse width light-emitting control transistor PWM_M6 and the pulse width light-emitting control signal line PWM_EM, thereby facilitating making the layout of the pixel driving circuit 11 more compact and saving the occupied space of the pixel driving circuit 11.

With continued reference to FIG. 3, and FIG. 7 to FIG. 30, in one or more embodiments, the pulse width adjustment module PWM further includes a pulse width compensation transistor PWM_M4, a pulse width gate reset transistor PWM_M5 and a pulse width storage capacitor PWM_C1. A first terminal PWM_M41 of the pulse width compensation transistor PWM_M4 is electrically connected to the second terminal PWM_M32 of the pulse width drive transistor PWM_M3, a second terminal PWM_M42 of the pulse width compensation transistor PWM_M4 is electrically connected to the gate PWM_M30 of the pulse width drive transistor PWM_M3, and a gate PWM_M40 of the pulse width compensation transistor PWM_M4 is electrically connected to the second scan signal line PWM_S2. A first terminal PWM_M51 of the pulse width gate reset transistor PWM_M5 is electrically connected to a first reset signal line PWM_REF, a second terminal PWM_M52 of the pulse width gate reset transistor PWM_M5 is electrically connected to the gate PWM_M30 of the pulse width drive transistor PWM_M3, a gate PWM_M50 of the pulse width gate reset transistor PWM_M5 is electrically connected to a first scan signal line PWM_S1, and the pulse width storage capacitor PWM_C1 is electrically connected to the gate PWM_M30 of the pulse width drive transistor PWM_M3. In the second direction Y, the pulse width compensation transistor PWM_M4 and the pulse width gate reset transistor PWM_M5 are both located on a side of the first terminal PWM_M31 of the pulse width drive transistor PWM_M3 away from the second terminal PWM_M32 of the pulse width drive transistor PWM_M3. In the first direction X, an arrangement direction of the pulse width gate reset transistor PWM_M5 and the pulse width compensation transistor PWM_M4 is the same as an arrangement direction of the pulse width drive transistor PWM_M3 and the pulse width storage capacitor PWM_C1.

In one or more embodiments, as shown in FIGS. 3, and FIGS. 7 to 30, in the pulse width adjustment module PWM, the pulse width compensation transistor PWM_M4 is connected in series between the gate PWM_M30 of the pulse width drive transistor PWM_M3 and the second terminal PWM_M32 of the pulse width drive transistor PWM_M3, and the gate PWM_M40 of the pulse width compensation transistor PWM_M4 is configured to receive a second scan signal provided by the second scan signal line PWM_S2. Under the control of the second scan signal, the pulse width compensation transistor PWM_M4 is turned on to communicate the gate PWM_M30 of the pulse width drive transistor PWM_M3 with the second terminal PWM_M32 of the pulse width drive transistor PWM_M3.

In the pulse width adjustment module PWM, the pulse width gate reset transistor PWM_M5 is connected in series between the gate PWM_M30 of the pulse width drive transistor PWM_M3 and the first reset signal line PWM_REF, and the gate PWM_M50 of the pulse width gate reset transistor PWM_M5 is configured to receive a second scan signal provided by the first scan signal line PWM_S1. Under the control of the second scan signal, the pulse width gate reset transistor PWM_M5 is turned on, and a first reset signal provided by the first reset signal line PWM_REF is transmitted to the gate PWM_M30 of the pulse width drive transistor PWM_M3 to reset the potential of the gate PWM_M30 of the pulse width drive transistor PWM_M3.

Further, the structure of the pulse width storage capacitor PWM_C1, the connection relationship among the pulse width storage capacitor PWM_C1 and other components, and the positional relationship between the pulse width drive transistor PWM_M3 and the pulse width storage capacitor PWM_C1 may be referred to any of the above-described embodiments, which is not limited in the embodiments of the present disclosure.

With continued reference to FIGS. 7, 21 and 30, in this embodiment, in the second direction Y, the pulse width compensation transistor PWM_M4 and the pulse width gate reset transistor PWM_M5 are both located on an upper side of the first terminal PWM_M31 of the pulse width drive transistor PWM_M3, and the second terminal PWM_M32 of the pulse width drive transistor PWM_M3 is located on a lower side of the first terminal PWM_M31 of the pulse width drive transistor PWM_M3. Moreover, in the first direction X, the pulse width gate reset transistor PWM_M5 is located on a left side of the pulse width compensation transistor PWM_M4, and the pulse width drive transistor PWM_M3 may likewise be located on the left side of the pulse width storage capacitor PWM_C1.

With the arrangement, a connection path of the first terminal PWM_M41 of the pulse width compensation transistor PWM_M4 and the second terminal PWM_M32 of the pulse width drive transistor PWM_M3 may bypass the first terminal PWM_M31 of the pulse width drive transistor PWM_M3, so that no overlapping area exists between the second terminal PWM_M32 of the pulse width drive transistor PWM_M3 and the first terminalPWM_M31 of the pulse width drive transistor PWM_M3 in the direction perpendicular to the plane where the base substrate is located, and the short circuit can be avoided from occurring between the second terminal PWM_M32 of the pulse width drive transistor PWM_M3 and the first terminal PWM_M31 of the pulse width drive transistor PWM_M3 while ensuring that no overlapping region exists between the first terminal PWM_M31 of the pulse width drive transistor PWM_M3 and the gate PWM_M30 of the pulse width drive transistor PWM_M3 in the direction perpendicular to the plane where the base substrate is located.

With continued reference to FIG. 22, in one or more embodiments, the gate PWM_M30 of the pulse width drive transistor PWM_M3 includes a fourth section 24 extending in the first direction X and a fifth section 25 extending in the second direction Y. The fourth section 24 and the fifth section 25 are connected to each other, and the fourth section 24 and the fifth section 25 are arranged in the first direction X. In the second direction Y, a boundary of the fourth section 24 on a side close to the first terminal PWM_M31 of the pulse width drive transistor PWM_M3 is a ninth boundary S9, and the ninth boundary S9 extends in the first direction X. In the first direction X, a boundary of the fifth section 25 on a side close to the first terminal PWM_M31 of the pulse width drive transistor PWM_M3 is a tenth boundary S10, and the tenth boundary S10 extends in the second direction Y. The ninth boundary S9 is contiguous with the tenth boundary S10.

In one or more embodiments, as shown in FIG. 22, a fourth section 24 of the gate PWM_M30 extends in the first direction X, and a fifth section 25 extends in the second direction Y, so that a corner structure is formed on the gate PWM_M30, thereby facilitating the electrical connection between the gate PWM_M30 and the pulse width storage capacitor PWM _C1.

In the second direction Y, the ninth boundary S9 of the fourth section 24 on the side close to the first terminal PWM_M31 of the pulse width drive transistor PWM_M3 extends in the first direction X. In the first direction X, the tenth boundary S10 of the boundary of the fifth section 25 on the side close to the first terminal PWM _M31 of the pulse width drive transistor PWM_M3 extends in the second direction Y. The ninth boundary S9 is contiguous with the tenth boundary S10, that is, the ninth boundary S9 is directly connected to the tenth boundary S10, and no gap or other boundary exists between the ninth boundary S9 and the tenth boundary S10. Moreover, no chamfer design is adopted between the ninth boundary S9 and the tenth boundary S10, so that the spacing between an abutment position of the ninth boundary S9 as well as the tenth boundary S10 and the first terminal PWM_M31 of the pulse width drive transistor PWM_M3 can be increased, thereby reducing the parasitic capacitance between the first terminal PWM_M31 of the pulse width drive transistor PWM_M3 and the gate PWM_M30 of the pulse width drive transistor PWM_M3, and reducing the unnecessary coupling power consumption. Moreover, the mutual interference of the voltages between the first terminal PWM_M31 of the pulse width drive transistor PWM_M3 and the gate PWM_M30 of the pulse width drive transistor PWM_M3 can also be reduced, thereby helping to achieve the accurate control of the working state of the pulse width drive transistor PWM_M3, reducing the control difficulty of the pixel driving circuit 11, and further facilitating improving the driving capability of the pixel driving circuit 11.

In an example, as shown in FIG. 22, when the first direction X is perpendicular to the second direction Y, an included angle θ10 between the ninth boundary S9 and the tenth boundary S10 may be a right angle, i.e., 010 = 90°, so that it is conducive to making the layout of the pixel driving circuit 11 more compact while increasing the effective spacing between a junction where the fourth section 24 as well as the fifth section 25 and the first terminal PWM_M31 of the pulse width drive transistor PWM_M3 and reducing the parasitic capacitance between the first terminal PWM_M31 of the pulse width drive transistor PWM_M3 and the gate PWM_M30 of the pulse width drive transistor PWM_M3, thereby saving the space, which is not limited thereto and is not limited in the embodiments of the present disclosure.

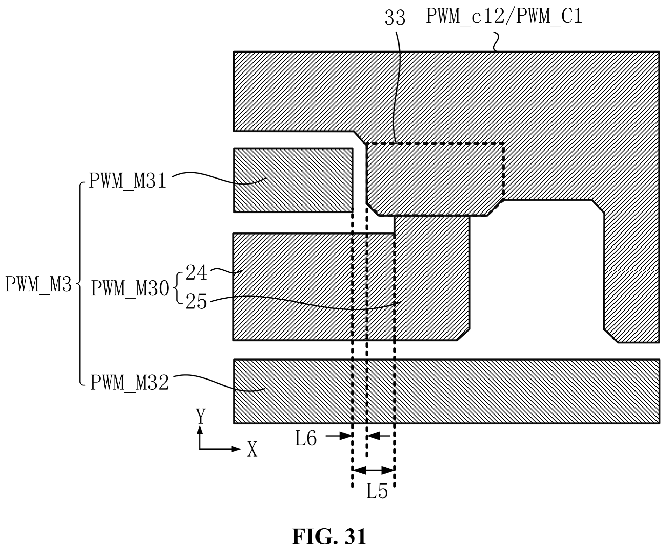

FIG. 31 is a schematic structural diagram of a gate of a pulse width drive transistor and a second connection section according to an embodiment of the present disclosure. As shown in FIG. 31, in one or more embodiments, the gate PWM_M30 of the pulse width drive transistor PWM_M3 includes a fourth section 24 extending in the first direction X and a fifth section 25 extending in the second direction Y. The fourth section 24 and the fifth section 25 are connected to each other, and the fourth section 24 and the fifth section 25 are arranged in the first direction X. The pulse width adjustment module PWM further includes a pulse width storage capacitor PWM_C1, the pulse width storage capacitor PWM_C1 includes a second plate PWM_c12, the second plate PWM_c12 includes a second connection section 33 connected to the fifth section 25, and the fifth section 25 and the second connection section 33 are arranged in the second direction Y. In the first direction X, a spacing between the fifth section 25 and the first terminal PWM_M31 of the pulse width drive transistor PWM_M3 is greater than a spacing between the second connection section 33 and the first terminal PWM_M31 of the pulse width drive transistor PWM_M3.

The structures of the pulse width drive transistor PWM_M3 and the pulse width storage capacitor PWM_C1, and the positional relationship between the pulse width drive transistor PWM_M3 and the pulse width storage capacitor PWM_C1 may be referred to any of the above-described embodiments, and the details are not repeated herein.

In this embodiment, as shown in FIG. 31, a second plate PWM_c12 of the pulse width storage capacitor PWM_C1 is electrically connected to the gate PWM_M30 of the pulse width drive transistor PWM_M3. The second connection section 33 connected to the fifth section 25 of the gate PWM_M30 is disposed on the second plate PWM_c12, the fifth section 25 and the second connection section 33 are arranged in the second direction Y, and the first terminal PWM_M31 of the pulse width drive transistor PWM_M3 and the second connection section 33 are arranged in the first direction X, so that the electrical connection between the second plate PWM_c12 of the pulse width storage capacitor PWM_C1 and the gate PWM_M30 of the pulse width drive transistor PWM_M3 is achieved, and the second plate PWM_c12 of the pulse width storage capacitor PWM_C1 and the gate PWM_M30 of the pulse width drive transistor PWM_M3 are arranged around the first plate PWM_M31, to ensure that no overlapping region exists between the first terminal PWM_M31 and the gate PWM_M30 and between the first terminal PWM_M31 and the second plate PWM_c12 in the direction perpendicular to the plane where the base substrate is located, thereby reducing the pulse parasitic capacitance between the gate PWM_M30 of the pulse width drive transistor PWM_M3 and the first terminal PWM_M31 of the pulse width drive transistor PWM_M3.

Further, as shown in FIG. 31, in the first direction X, a spacing L5 between the fifth section 25 and the first terminal PWM_M31 is set to be greater than a spacing L6 between the second connection section 33 and the first terminal PWM_M31 of the pulse width drive transistor PWM_M3 to increase, in the first direction X, the spacing between the fifth section 25 of the gate PWM_M30 and the first terminal PWM_M31, thereby facilitating reducing the parasitic capacitance between the gate PWM_M30 of the pulse width drive transistor PWM_M3 and the first terminal PWM_M31 and reducing the unnecessary coupling power consumption. Moreover, the mutual interference of voltages between the gate PWM_M30 of the pulse width drive transistor PWM_M3 and the first terminal PWM_M31 can be reduced, thereby helping to achieve the accurate control of the working state of the pulse width drive transistor PWM_M3, reducing the control difficulty of the pixel driving circuit 11, and further facilitating improving the driving capability of the pixel driving circuit 11.

The spacing L5 between the fifth section 25 and the first terminal PWM_M31 may be set to be greater than or equal to 1 µm to ensure that a parasitic capacitance between the gate PWM_M30 of the pulse width drive transistor PWM_M3 and the first terminal PWM_M31 is relatively small. Further, the spacing L5 between the fifth section 25 and the first terminal PWM_M31 may be set to be greater than or equal to 2.5 µm, to ensure that the parasitic capacitance between the gate PWM_M30 of the pulse width drive transistor PWM_M3 and the first terminal PWM_M31 of the pulse width drive transistor PWM_M3 remains at the low level under the condition of the existence of the process error, which is not limited in the embodiments of the present disclosure.

It is to be noted that the connection structure, specific shape and dimensions between the fifth section 25 of the gate PWM_M30 and the second connection section 33 of the second plate PWM_c12 may be set with reference to the connection structure, specific shape and dimensions between the third section 23 of the first electrode M31 and the first connection section 31 of the first plate c11 in the above-described embodiments, to reduce the signal interference between the gate PWM_M30 and other signal lines or nodes while ensuring the electrical connection performance between the gate PWM_M30 and the second plate PWM_c12, and to prevent the generation of tip-end static electricity, and the details are not repeated herein.

With continued reference to FIGS. 3 to FIGS. 9, and FIGS. 14 to FIGS. 30, in one or more embodiments, the amplitude adjustment module PAM may include a first amplitude light-emitting control transistor PAM_M1, an amplitude data write transistor PAM_M2, an amplitude drive transistor PAM_M3, an amplitude compensation transistor PAM_M4, an amplitude gate reset transistor PAM_M5, a second amplitude light-emitting control transistor PAM_M6, an amplitude reset transistor PAM_M7, and an amplitude storage capacitor PAM_C1.

The amplitude drive transistor PAM_M3 is connected in series between the second power line PAM_VDD and the light-emitting element 12, and the amplitude drive transistor PAM_M3 may generate a drive current based on the amplitude data signal and the second power voltage provided by the second power line PAM_VDD to drive the light-emitting element 12 to emit light. The constant drive current may be generated by providing an amplitude data signal with the same voltage value to the amplitude drive transistor PAM_M3. It is to be noted that for the pixel driving circuit 11 to which light-emitting elements 12 of different colors are connected, an amplitude data signal with different voltage values may be supplied to the amplitude drive transistor PAM_M3 thereof.

The amplitude gate reset transistor PAM_M5 is connected in series between the second reset signal line PAM_REF and the gate of the amplitude drive transistor PAM_M3, and a gate of the amplitude gate reset transistor PAM_M5 is configured to receive a third scan signal provided by a third scan signal line PAM_S1. Under the control of the third scan signal, the amplitude gate reset transistor PAM_M5 is turned on, and the second reset signal provided by the second reset signal line PAM_REF is transmitted to the gate of the amplitude drive transistor PAM_M3 to reset the potential of the gate of the amplitude drive transistor PAM_M3.

The amplitude data write transistor PAM_M2 is connected in series between the amplitude data signal line PAM_DATA and the first terminal of the amplitude drive transistor PAM_M3, and the gate of the amplitude data write transistor PAM_M2 is configured to receive a fourth scan signal provided by the fourth scan signal line PAM_S2. Under the control of the fourth scan signal, the amplitude data write transistor PAM_M2 is turned on and transmits the amplitude data signal provided by the amplitude data signal line PAM_DATA to the first terminal of the amplitude drive transistor PAM_M3.

The amplitude compensation transistor PAM_M4 is connected in series between the second terminal of the amplitude drive transistor PAM_M3 and the gate of the amplitude drive transistor PAM_M3, and the gate of the amplitude compensation transistor PAM_M4 is configured to receive the third scan signal provided by the third scan signal line PAM_S1. Under the control of the third scan signal, the amplitude compensation transistor PAM_M4 is turned on, to communicate the second terminal of the amplitude drive transistor PAM_M3 with the gate of the amplitude drive transistor PAM_M3.

The amplitude data write transistor PAM_M2 and the amplitude compensation transistor PAM_M4 may be turned on under the control of the same third scan signal, to transmit an amplitude data signal provided by the amplitude data signal line PAM_DATA to the gate of the amplitude drive transistor PAM_M3. A threshold voltage of the amplitude drive transistor PAM_M3 is provided to the gate of the amplitude drive transistor PAM_M3 in a self-compensating manner, so that the effect of the threshold voltage of the amplitude drive transistor PAM_M3 on the amplitude of the drive current generated from the amplitude drive transistor PAM_M3 can be eliminated.

The first amplitude light-emitting control transistor PAM_M1 is connected in series between the second power line PAM_VDD and the amplitude drive transistor PAM_M3, and a gate of the first amplitude light-emitting control transistor PAM_M1 is configured to receive an amplitude light-emitting control signal provided by the amplitude light-emitting control signal line PAM_EM. Under the control of the amplitude light-emitting control signal, the first amplitude light-emitting control transistor PAM_M1 is turned on and transmits the second power voltage provided by the second power line PAM_VDD to the first terminal of the drive transistor PAM_M3.

The second amplitude light-emitting control transistor PAM_M6 is connected in series between the amplitude drive transistor PAM_M3 and an anode of the light-emitting element 12, and a gate of the second amplitude light-emitting control transistor PAM_M6 is configured to receive the amplitude light-emitting control signal provided by the amplitude light-emitting control signal line PAM_EM. Under the control of the amplitude light-emitting control signal, the second amplitude light-emitting control transistor PAM_M6 is turned on to establish a connection for the path between the amplitude drive transistor PAM_M3 and the light-emitting element 12.

The first amplitude light-emitting control transistor PAM_M1 and the second amplitude light-emitting control transistor PAM_M6 may be turned on under the control of the same amplitude light-emitting control signal, to establish a connection for the drive current path between the second power line PAM_VDD and the light-emitting element 12.

The amplitude reset transistor PAM_M7 is connected in series between the anode of the light-emitting element 12 and the third reset signal line PAM_INIT, and a gate of the amplitude reset transistor PAM_M7 is configured to receive the fourth scan signal provided by the fourth scan signal line PAM_S2. Under the control of the fourth scan signal, the amplitude reset transistor PAM_M7 is turned on, and the third reset signal provided by the third reset signal line PAM_INIT is transmitted to the anode of the light-emitting element 12 to reset the potential of the anode of the light-emitting element 12.

The amplitude storage capacitor PAM_C1 is connected in series between the second power line PAM_VDD and the gate PAM_M30 of the amplitude drive transistor PAM_M3 and is configured to receive an amplitude data signal written to the gate PAM_M30 of the amplitude drive transistor PAM_M3 and maintain the potential of the gate PAM_M30 of the amplitude drive transistor PAM_M3, thereby enabling the amplitude drive transistor PAM_M3 to continuously provide the constant drive current.

With continued reference to FIGS. 3-FIG. 9, and FIGS. 14-FIG. 30, in one or more embodiments, the pulse width adjustment module PWM may include a first pulse width light-emitting control transistor PWM_M1, a pulse width data write transistor PWM_M2, a pulse width drive transistor PWM_M3, a pulse width compensation transistor PWM_M4, a pulse width gate reset transistor PWM_M5, a second pulse width light-emitting control transistor PWM_M6, and pulse width storage capacitor PWM_C1.

The pulse width drive transistor PWM_M3 is connected in series between the first power line PWM_VDD and the gate of the amplitude drive transistor PAM_M3, and the pulse width drive transistor PWM_M3 is configured to transmit the first power voltage provided by the first power line PWM_VDD to the gate of the amplitude drive transistor PAM_M3, to control the amplitude drive transistor PAM_M3 to be cut off, so that a turn-on duration of the amplitude drive transistor PAM_M3 can be controlled, that is, the duration of the drive current can be controlled, to cause the light-emitting element 12 to present the brightness level of a corresponding gray scale.

The pulse width gate reset transistor PWM_M5 is connected in series between the gate PWM_M30 of the pulse width drive transistor PWM_M3 and the first reset signal line PWM_REF, and the gate of the pulse width gate reset transistor PWM_M5 is configured to receive the second scan signal provided by the first scan signal line PWM_S1. Under the control of the second scan signal, the pulse width gate reset transistor PWM_M5 is turned on, and the first reset signal provided by the first reset signal line PWM_REF is transmitted to the gate of the pulse width drive transistor PWM_M3 to reset the potential of the gate of the pulse width drive transistor PWM_M3.

The pulse width data write transistor PWM_M2 is connected in series between the pulse width data signal line PWM_DATA and the first terminal of the pulse width drive transistor PWM_M3, and a gate of the pulse width data write transistor PWM_M2 is configured to receive a second scan signal provided by the second scan signal line PWM_S2. Under the control of the second scan signal, the pulse width data write transistor PWM_M2 is turned on and transmits the pulse width data signal provided by the pulse width data signal line PWM_DATA to the first terminal of the pulse width drive transistor PWM_M3.

The pulse width compensation transistor PWM_M4 is connected in series between the gate of the pulse width drive transistor PWM_M3 and the second terminal of the pulse width drive transistor PWM_M3, and the gate PWM_M40 of the pulse width compensation transistor PWM_M4 is configured to receive the second scan signal provided by the second scan signal line PWM_S2. Under the control of the second scan signal, the pulse width compensation transistor PWM_M4 is turned on to communicate the gate of the pulse width drive transistor PWM_M3 and the second terminal of the pulse width drive transistor PWM_M3.

Further, the pulse width data write transistor PWM_M2 and the pulse width compensation transistor PWM_M4 may be turned on under the control of the same second scan signal to transmit the pulse width data signal provided by the pulse width data signal line PWM_DATA to the gate of the pulse width drive transistor PWM_M3. A threshold voltage of the pulse width drive transistor PWM_M3 is provided to the gate of the pulse width drive transistor PWM_M3 in a self-compensating manner, so that the effect of different pulse width drive transistors PWM_M3 in the display panel on the display uniformity due to different threshold voltages can be reduced or eliminated.

The first pulse width light-emitting control transistor PWM_M1 is connected in series between the first power line PWM_VDD and the first terminal PWM_M31 of the pulse width drive transistor PWM_M3, and the gate of the first pulse width light-emitting control transistor PWM_M1 is configured to receive the first pulse width light-emitting control signal provided by the pulse width light-emitting control signal line PWM_EM. Under the control of the first pulse width light-emitting control signal, the first pulse width light-emitting control transistor PWM_M1 is turned on and transmits the first power voltage provided by the first power line PWM_VDD to the first terminal of the pulse width drive transistor PWM_M3.

The second pulse width light-emitting control transistor PWM_M6 is connected in series between the second terminal of the pulse width drive transistor PWM_M3 and the gate of the amplitude drive transistor PAM_M3 in the amplitude adjustment module PAM, and the gate of the second pulse width light-emitting control transistor PWM_M6 is configured to receive the first pulse width light-emitting control signal provided by the pulse width light-emitting control signal line PWM_EM. Under the control of the first pulse width light-emitting control signal, the second pulse width light-emitting control transistor PWM_M6 is turned on, and the first power line PWM_VDD and the gate of the amplitude drive transistor PAM_M3 are enabled to transmit the first power voltage provided by the first power line PWM_VDD to the gate of the amplitude drive transistor PAM_M3 to control the amplitude drive transistor PAM_M3 to be cut off, thereby controlling a duration of the drive current provided by the amplitude adjustment module PAM.

The pulse width storage capacitor PWM_C1 is connected in series between the sweep signal line SWEEP and the gate of the pulse width drive transistor PWM_M3, and the pulse width storage capacitor PWM_C1 is configured to receive the pulse width data signal written to the gate of the pulse width drive transistor PWM_M3 and to maintain the potential of the gate of the pulse width drive transistor PWM_M3.

The sweep signal line SWEEP is configured to provide a sweep signal. The sweep signal may be in the form of a triangle wave, for example, the sweep signal may decrease linearly from a high level to a low level, or the sweep signal may increase linearly from a low level to a high level. When the pulse of the sweep signal is applied to the pulse width storage capacitor PWM_C1, the potential on the other plate (the plate connected to the gate of the pulse width drive transistor PWM_M3) of the pulse width storage capacitor PWM_C1 changes correspondingly in synchronization under the bootstrap effect of the pulse width storage capacitor PWM_C1, that is, the pulse change of the sweep signal may be reflected to the potential on the gate of the pulse width drive transistor PWM_M3 through the pulse width storage capacitor PWM_C1, and the potential on the gate of the pulse width drive transistor PWM_M3 changes linearly in synchronization

The working process of the pixel driving circuit 11 may include, but is not limited to, a first reset stage, a first data write stage, a second reset stage, a second data write stage, and a light-emitting stage.

In the first reset stage, the third scan signal provided by the third scan signal line PAM_S1 controls the amplitude gate reset transistor PAM_M5 to be turned on, and the second reset signal provided by the second reset signal line PAM_REF is transmitted to the gate of the amplitude drive transistor PAM_M3 through the amplitude gate reset transistor PAM_M5, which makes the gate of the amplitude drive transistor PAM_M3 of the amplitude drive transistor PAM_M3 have the same potential as the potential of the second reset signal.

In the first data write stage, the fourth scan signal provided by the fourth scan signal line PAM_S2 controls the amplitude data write transistor PAM_M2 and the amplitude compensation transistor PAM_M4 to be turned on, and the amplitude data signal provided by the amplitude data signal line PAM_DATA is written to the gate of the amplitude drive transistor PAM_M3. The potential of the gate of the amplitude drive transistor PAM_M3 also contains a self-compensated threshold voltage of the amplitude drive transistor PAM_M3, so that the effect of the threshold voltage of the amplitude drive transistor PAM_M3 on the amplitude of the drive current generated therefrom can be eliminated.

Moreover, in the first data write stage, in one or more embodiments, the fourth scan signal provided by the fourth scan signal line PAM_S2 controls the amplitude reset transistor PAM_M7 to be turned on, and the third reset signal provided by the third reset signal line PAM_INIT is transmitted to the anode of the light-emitting element 12, to reset the potential of the anode of the light-emitting element 12.

In the second reset stage, the second scan signal provided by the first scan signal line PWM_S1 controls the pulse width gate reset transistor PWM_M5 to be turned on, and the first reset signal provided by the first reset signal line PWM_REF is transmitted to the gate of the pulse width drive transistor PWM_M3 through the pulse width gate reset transistor PWM_M5, which makes the gate of the pulse width drive transistor PWM_M3 has the same potential as the potential of the first reset signal.

In the second data write stage, the second scan signal provided by the second scan signal line PWM_S2 controls the pulse width data write transistor PWM_M2 and the pulse width compensation transistor PWM_M4 to be turned on, and the pulse width data signal provided by the pulse width data signal line PWM_DATA is written to the gate of the pulse width drive transistor PWM_M3. The potential of the gate of the pulse width drive transistor PWM_M3 also contains a self-compensated threshold voltage of the pulse width drive transistor PWM_M3, so that the effect of different pulse width drive transistors PWM_M3 in the display panel on the display uniformity due to different threshold voltages can be reduced or eliminated.

In the light-emitting stage, the amplitude light-emitting control signal provided by the amplitude light-emitting control signal line PAM_EM controls the first amplitude light-emitting control transistor PAM_M1 and the second amplitude light-emitting control transistor PAM_M6 to be turned on, and the first pulse width light-emitting control signal provided by the pulse width light-emitting control signal line PWM_EM controls the first pulse width light-emitting control transistor PWM_M1 and the second pulse width light-emitting control transistor PWM_M1 to be turned on. The voltage value of the sweep signal provided by the sweep signal line SWEEP changes linearly and is reflected to the gate of the pulse width drive transistor PWM_M3 through the bootstrap effect of the pulse width storage capacitor PWM_C1, so that the potential of the gate of the pulse width drive transistor PWM_M3 changes synchronously.

An example in which the pulse width drive transistor PWM_M3 adopts a P-type transistor is used for illustration, the sweep signal may be linearly reduced from a high level to a low level.

When the pulse width drive transistor PWM_M3 is in the cut-off state, the first power voltage provided by the first power line PWM_VDD is not transmitted to the gate of the amplitude drive transistor PAM_M3, and the amplitude drive transistor PAM_M3 generates a drive current based on the amplitude data signal provided by the amplitude data signal line PAM_DATA and the second power voltage provided by the second power line PAM_VDD to cause the light-emitting element 12 to emit light.

Further, in the process of linearly decreasing the sweep signal, the potential of the gate of the pulse width drive transistor PWM_M3 decreases synchronously, and when the potential of the gate of the pulse width drive transistor PWM_M3 changes to be comparable to or less than the potential (i.e., the first power voltage provided by the first power line PWM_VDD) of the source, the pulse width drive transistor PWM_M3 is turned on, thereby transmitting the first power voltage provided by the first power line PWM_VDD to the gate of the amplitude drive transistor PAM_M3, causing the amplitude drive transistor PAM_M3 to cut off, causing the amplitude drive transistor PAM_M3 to no longer provide the drive current to the light-emitting element 12, and further causing the drive light-emitting element 12 to stop emitting light.

With continued reference to FIGS. 14 to 21, in one or more embodiments, the pulse width adjustment module PWM further includes a sweep transistor PWM_M7, the sweep transistor PWM_M7 is connected in series between the sweep constant voltage signal line SWEEP_GND and the pulse width storage capacitor PWM_C1 (such as, the plate, connected to the sweep signal line SWEEP, in the pulse width storage capacitor PWM_C1), the gate of the sweep transistor PWM_M7 is configured to receive the second scan signal provided by the second scan signal line PWM_S2. Under the control of the second sweep signal, the sweep transistor PWM_M7 is turned on and transmits the sweep constant voltage provided by the sweep constant voltage signal line SWEEP_GND to the pulse width storage capacitor PWM_C1, and the sweep constant voltage may be the same as the high level of the sweep signal, or the sweep constant voltage may be the same as the low level of the sweep signal. In this case, the sweep constant voltage signal line SWEEP_GND and the sweep signal line SWEEP provide a signal to one plate of the pulse width storage capacitor PWM_C1 (such as, the plate, connected to the sweep signal line SWEEP, in the pulse width storage capacitor PWM_C1), so that the stabilization of the potential of this plate of the pulse width storage capacitor PWM_C1 can be further ensured, and the signal disturbance caused by peripheral signals can be reduced.

With continued reference to FIGS. 14 to FIG. 21, in one or more embodiments, the amplitude adjustment module PAM further includes an eighth transistor PAM_M8, the eighth transistor PAM_M8 is connected in series between the amplitude storage capacitor PAM_C1 and the second power line PAM_VDD, and a gate of the eighth transistor PAM_M8 is configured to receive a first pulse width light-emitting control signal provided by the pulse width light-emitting control signal line PWM_EM. Under the control of the first pulse width light-emitting control signal, the eighth transistor PAM_M8 is turned on and transmits the second power voltage provided by the second power line PAM_VDD to the amplitude storage capacitor PAM_C1, so that the second power voltage is applied to the amplitude adjustment module PAM during the light-emitting stage, to achieve the provision of the drive current to the light-emitting element 12.

With continued reference to FIGS. 14 to FIG. 21, in one or more embodiments, the amplitude adjustment module PAM further includes a ninth transistor PAM_M9 and a tenth transistor PAM_M10. The ninth transistor PAM_M9 is connected in series between the first power line PWM_VDD and the amplitude storage capacitor PAM_C1, and a gate of the ninth transistor PAM_M9 is configured to receive the third scan signal provided by the third scan signal line PAM_S1. Under the control of the third scan signal, the ninth transistor PAM_M9 is turned on and transmits the first power voltage provided by the first power line PWM_VDD to the amplitude storage capacitor PAM_C1. The tenth transistor PAM_M10 is also connected in series between the first power line PWM_VDD and the amplitude storage capacitor PAM_C1, and a gate of the tenth transistor PAM_M10 is configured to receive the fourth scan signal provided by the fourth scan signal line PAM_S2. Under the control of the fourth scan signal, the tenth transistor PAM_M10 is turned on and transmits the first power voltage provided by the first power line PWM_VDD to the amplitude storage capacitor PAM_C1, thereby applying the first power voltage to the amplitude adjustment module in the first reset stage and the first data write stage PAM.

With continued reference to FIGS. 14 to FIG. 21, in one or more embodiments, the amplitude adjustment module PAM further includes a second capacitor PAM_C2, the second capacitor PAM_C2 is connected in series between the third reset signal line PAM_INIT and the amplitude storage capacitor PAM_C1, so that the potential of the plate of the amplitude storage capacitor PAM_C1 can be stabilized.

In one or more embodiments, in the pixel driving circuit 11, part of the transistors adopts the double-gate transistor. The double-gate transistor may include two transistors connected in series with each other, and two gates of the double-gate transistor are configured to receive the same control signal.

For example, as shown in FIGS. 3 and 14, the amplitude compensation transistor PAM_M4 and the amplitude gate reset transistor PAM_M5 in the amplitude adjustment module PAM may adopt the double-gate transistor, to reduce the leakage current of the amplitude compensation transistor PAM_M4 and the amplitude gate reset transistor PAM_M5, and further reduce the influence of the leakage current on the potential of the gate of the amplitude drive transistor PAM_M3.

For another example, as shown in FIGS. 3 and 14, the pulse width compensation transistor PWM_M4 and the pulse width gate reset transistor PWM_M5 in the pulse width adjustment module PWM may adopt the double-gate transistor, to reduce the leakage current in the pulse width compensation transistor PWM_M4 and the pulse width gate reset transistor PWM_M5, and further reduce the influence of the leakage current on the potential of the gate of the pulse width drive transistor PWM_M3.

It is to be noted that in the above-described embodiments, FIG. 3 exemplarily shows a circuit structure of a 13T2C (i.e., including 13 transistors and 2 capacitors), and FIG. 14 exemplarily illustrates a circuit structure of a 17T3C (i.e., including 17 transistors and 3 capacitors), which is not limited thereto and is not limited in the embodiments of the present disclosure.

With continued reference to FIGS. 15 to FIG. 30, in one or more embodiments, an active layer of the first amplitude light-emitting control transistor PAM_M1, an active layer of the amplitude data write transistor PAM_M2, an active layer of the amplitude drive transistor PAM_M3, an active layer of the amplitude compensation transistor PAM_M4, an active layer of the amplitude gate reset transistor PAM_M5, an active layer of the second amplitude light-emitting control transistor PAM_M6, an active layer of the amplitude reset transistor PAM_M7, an active layer of the first pulse width light-emitting control transistor PWM_M1, an active layer of the pulse width data write transistor PWM_M2, an active layer of the pulse width drive transistor PWM_M3, an active layer of the pulse width compensation transistor PWM_M4, an active layer of the pulse width gate reset transistor PWM_M5, and an active layer of the second pulse width light-emitting control transistor PWM_M6 may be located in the semiconductor layer POLY.

A bottom gate of the first amplitude light-emitting control transistor PAM_M1, a bottom gate of the amplitude data write transistor PAM_M2, a bottom gate of the amplitude drive transistor PAM_M3, a bottom gate of the amplitude compensation transistor PAM_M4, a bottom gate of the amplitude gate reset transistor PAM_M5, a bottom gate of the second amplitude light-emitting control transistor PAM_M6, a bottom gate of the amplitude reset transistor PAM_M7, a bottom gate of the first pulse width light-emitting control transistor PWM_M1, a bottom gate of the pulse width data write transistor PWM_M2, a bottom gate of the pulse width drive transistor PWM_M3, a bottom gate of the pulse width compensation transistor PWM_M4, a bottom gate of the pulse width gate reset transistor PWM_M5, and a bottom gate of the second pulse width light-emitting control transistor PWM_M6 may be located in the first metal layer M0.

A top gate of the first amplitude light-emitting control transistor PAM_M1, a top gate of the amplitude data write transistor PAM_M2, a top gate of the amplitude drive transistor PAM_M3, a top gate of the amplitude compensation transistor PAM_M4, a top gate of the amplitude gate reset transistor PAM_M5, a top gate of the second amplitude light-emitting control transistor PAM_M6, a top gate of the amplitude reset transistor PAM_M7, a top gate of the first pulse width light-emitting control transistor PWM_M1, a top gate of the pulse width data write transistor PWM_M2, a top gate of the pulse width drive transistor PWM_M3, a top gate of the pulse width compensation transistor PWM_M4, a top gate of the pulse width gate reset transistor PWM_M5, and a top gate of the second pulse width light-emitting control transistor PWM_M6, as well as one plate of the amplitude storage capacitor PAM_C1 and one plate of the pulse width storage capacitor PWM_C1 may be located in the second metal layer GAT.

The second metal layer GAT may further include a first scan signal line PWM_S1, a second scan signal line PWM_S2, a sweep signal line SWEEP, a first power line PWM_VDD, a pulse width light-emitting control signal line PWM_EM, a third reset signal line PAM_INIT, a third scan signal line PAM_S1, a fourth scan signal line PAM_S2, and an amplitude light-emitting control signal line PAM_EM, which extend in the first direction X.

The third metal layer MC may include another plate of the amplitude storage capacitor PAM_C1 and another plate of the pulse width storage capacitor PWM_C1, and may include the first reset signal line PWM_REF and the second reset signal line PAM_REF which extend in the first direction X.

The fourth metal layer SD1 may include the pulse width data signal line PWM_DATA and the amplitude data signal line PAM_DATA which extend in the second direction Y.

With continued reference to FIGS. 15 to 21, in one or more embodiments, an active layer of the sweep transistor PWM_M7, an active layer of the eighth transistor PAM_M8, an active layer of the ninth transistor PAM_M9, and an active layer of the tenth transistor PAM_M10 may be located in the semiconductor layer POLY.

A bottom gate of the sweep transistor PWM_M7, a bottom gate of the eighth transistor PAM_M8, a bottom gate of the ninth transistor PAM_M9, and a bottom gate of the tenth transistor PAM_M10 may be located in the first metal layer M0.

A top gate of the sweep transistor PWM_M7, a top gate of the eighth transistor PAM_M8, a top gate of the ninth transistor PAM_M9, and a top gate of the tenth transistor PAM_M10 top gate, and one plate of the second capacitor PAM_C2 may be located in the second metal layer GAT.

The sweep constant voltage signal line SWEEP_GND extending in the first direction X may also be included in the second metal layer GAT.

Another plate of the second capacitor PAM_C2 may also be included in the third metal layer MC.

It is to be noted that for the specific film layer setting of the display panel, the adaptive adjustments can be made according to actual requirements, such as adding or subtracting part of film layers, which is not limited in the embodiments of the present disclosure.

With continued reference to FIGS. 7, 21 and 30, in one or more embodiments, an overlapping region exists between a wire extending in the first direction X and a wire extending in the second direction Y. In the overlapping region, an overlapping area between the wire extending in the first direction X and the wire extending in the second direction Y can be reduced by reducing a line width of the wire extending in the first direction X and/or a line width of the wire extending in the second direction Y, and the parasitic capacitance formed between the wire extending in the first direction X and the wire extending in the second direction Y, thereby further reducing the unnecessary coupling power consumption. Moreover, the mutual interference of voltages between the wire extending in the first direction X and the wire extending in the second direction Y can also be reduced, thereby helping to achieve the accurate control of the potential of each node, reducing the control difficulty of the pixel driving circuit 11, and further facilitating improving the driving capability of the pixel driving circuit 11.

In an example, as shown in FIGS. 16 to 21 and FIGS. 25 to 30, in one or more embodiments, the pulse width data write transistor PWM_M2 is connected to the first terminal of the pulse width drive transistor PWM _M31 through the first signal line a1 extending in the second direction Y, and the sweep signal line SWEEP extends in the first direction X. In the direction perpendicular to the plane where the base substrate is located, an overlapping region of the first signal line a1 and the sweep signal line SWEEP is a first region Z1. A line width of the first signal line a1 in the first region Z1 is set to be less than a line width of the first signal line a1 in a region other than the first region Z1, to narrow the first signal line a1 in the first region Z1, thereby reducing the overlapping area between the first signal line a1 and the sweep signal line SWEEP, and further reducing the parasitic capacitance formed between the first signal line a1 and the sweep signal line SWEEP.

As shown in FIGS. 16 to 21 and FIGS. 25 to 30, in one or more embodiments, the pulse width compensation transistor PWM_M4 is connected to the second terminal PWM_M32 of the pulse width drive transistor PWM_M3 through a second signal line a2 extending in the second direction Y, and the sweep signal line SWEEP extends in the first direction X. In the direction perpendicular to the plane where the base substrate is located, an overlapping region of the second signal line a2 and the sweep signal line SWEEP is a second region Z2. A line width of the second signal line a2 in the second region Z2 is set to be less than a line width of the second signal line a2 in a region other than the second region Z2, to narrow the second signal line a2 in the second region Z2, thereby reducing the overlapping area between the second signal line a2 and the sweep signal line SWEEP, and further reducing the parasitic capacitance formed between the second signal line a2 and the sweep signal line SWEEP.

As shown in FIGS. 16 to 21 and FIGS. 25 to 30, in one or more embodiments, the first terminal PWM_M31 of the pulse width drive transistor PWM_M3 is connected to the first pulse width light-emitting control transistor PWM_M1 through a third signal line a3 extending in the second direction Y, the first power line PWM_VDD extends in the first direction X, and the pulse width light-emitting control signal line PWM_EM extends in the first direction X. In the direction perpendicular to the plane where the base substrate is located, an overlapping region of the third signal line a3 and the first power line PWM_VDD is a third region Z3, and an overlapping region of the third signal line a3 and the pulse width light-emitting control signal line PWM_EM is the fourth region Z4. A line width of the third signal line a3 in the third region Z3 and the fourth region Z4 is less than a line width of the third signal line a3 in a region other than the third region Z3 and the fourth region Z4. Z4, to narrow the third signal line a3 in the third region Z3 and the fourth region Z4, thereby reducing an overlapping region between the third signal line a3 and the first power line PWM_VDD and the pulse width light-emitting control signal line PWM_EM, and further reducing the parasitic capacitance formed between the third signal line a3 and the first power line PWM_VDD and the pulse width light-emitting control signal line PWM_EM.

As shown in FIGS. 16 to 21 and FIGS. 25 to 30, in one or more embodiments, the second pulse width light-emitting control transistor PWM_M6 is connected to the second terminal PWM_M32 of the pulse width drive transistor PWM_M3 through the fourth signal line a4 extending in the second direction Y, and the first power line PWM_VDD extends in the first direction X. In the direction perpendicular to the plane where the base substrate is located, an overlapping region of the fourth signal line a4 and the first power line PWM_VDD is a fifth region Z5. A line width of the fourth signal line a4 in the fifth region Z5 is set to be less than a line width of the fourth signal line a4 in a region other than the fifth region Z5, to narrow the fourth signal line a4 in the fifth region Z5, thereby reducing an overlapping area between the fourth signal line a4 and the first power line PWM_VDD, and further reducing the parasitic capacitance formed between the fourth signal line a4 and the first power line PWM_VDD.

As shown in FIGS. 25 to FIG. 30, in one or more embodiments, a line width of the first power line PWM_VDD in the third region Z3 and the fifth region Z5 is less than a line width of the first power line PWM_VDD in a region other than the third region Z3 and the fifth region Z5, to narrow the first power line PWM_VDD in the third region Z3 and the fifth region Z5, thereby reducing an overlapping area between the first power line PWM_VDD and the third signal line a3 and the fourth signal line a4, and further reducing the parasitic capacitance formed between the first power line PWM_VDD and the third signal line a3 and the fourth signal line a4.

As shown in FIGS. 16 to FIG. 21 and FIGS. 25 to FIG. 30, in one or more embodiments, the second pulse width light-emitting control transistor PWM_M6 is connected to the amplitude storage capacitor PAM_C1 through a fifth signal line a5 extending in the second direction Y, and the fourth scan signal line PAM_S2 extends in the first direction X. In the direction perpendicular to the plane where the base substrate is located, an overlapping region of the fifth signal line a5 and the fourth scan signal line PAM_S2 is a sixth region Z6. A line width of the fifth signal line a5 in the sixth region Z6 is set to be less than a line width of the fifth signal line a5 in a region other than the sixth region Z6, to narrow the fifth signal line a5 in the sixth region Z6, thereby reducing an overlapping area between the fifth signal line a5 and the fourth scan signal line PAM_S2, and further reducing the parasitic capacitance formed between the fifth signal line a5 and the fourth scan signal line PAM_S2.

As shown in FIGS. 16 to 21 and FIGS. 25 to 30, in one or more embodiments, the sweep transistor PWM_M7 is connected to the third reset signal line PAM_INIT through the sixth signal line a6 extending in the second direction Y, the second reset signal line PAM_REF extends in the first direction X, and the third scan signal line PAM_S1 extends in the first direction X. In the direction perpendicular to the plane where the base substrate is located, an overlapping region of the sixth signal line a6 and the second reset signal line PAM_REF is a seventh region Z7, and an overlapping region of the sixth signal line a6 and the third scan signal line PAM_S1 is an eighth region Z8. A line width of the sixth signal line a6 in the seventh region Z7 and the eighth region Z8 is set to be less than a line width of the sixth signal line a6 in a region other than the seventh region Z7 and the eighth region Z8, to narrow the sixth signal line a6 in the seventh region Z7 and the eighth region Z8, thereby reducing an overlapping area between the sixth signal line a6 and the second reset signal line PAM_REF and the third scan signal line PAM_S1, and further reducing the parasitic capacitance formed between the sixth signal line a6 and the second reset signal line PAM_REF and the third scan signal line PAM_S1.

As shown in FIGS. 16 to 21 and FIGS. 25 to 30, in one or more embodiments, the amplitude data signal line PAM_DATA extends in the second direction Y, the fourth scan signal line PAM_S2 extends in the first direction X, and the amplitude light-emitting control signal line PAM_EM extends in the first direction X. In the direction perpendicular to the plane where the base substrate is located, an overlapping region of the amplitude data signal line PAM_DATA and the fourth scan signal line PAM_S2 is a ninth region Z9, and an overlapping region of the amplitude data signal line PAM_DATA and the amplitude light-emitting control signal line PAM_EM is a tenth region Z10. A line width of the amplitude data signal line PAM_DATA in the ninth region Z9 and the tenth region Z10 is less than a line width of the amplitude data signal line PAM_DATA in a region other than the ninth region Z9 and the tenth region Z10, to narrow the amplitude data signal line PAM_DATA in the ninth region Z9 and the tenth region Z10, thereby reducing an overlapping area between the amplitude data signal line PAM_DATA and the fourth-scan signal line PAM_S2 as well as the amplitude light-emitting control signal line PAM_EM, and further reducing the parasitic capacitance formed between the amplitude data signal line PAM_DATA and the fourth-scan signal line PAM_S2 as well as the amplitude light-emitting control signal line PAM_EM.

As shown in FIGS. 16 to 21 and FIGS. 25 to 30, in one or more embodiments, the pulse width compensation transistor PWM_M4 is connected to the pulse width storage capacitor PWM_C1 through the eighth signal line a8 extending in the second direction Y, and the sweep signal line SWEEP extends in the first direction X. In the direction perpendicular to the plane where the base substrate is located, an overlapping region of the eighth signal line a8 and the sweep signal line SWEEP is a twelfth region Z12. A line width of the eighth signal line a8 in the twelfth region Z12 is set to be less than a line width of the eighth signal line a8 in a region other than the twelfth region Z12, to narrow the eighth signal line a8 in the twelfth region Z12, thereby reducing an overlapping area between the eighth signal line a8 and the sweep signal line SWEEP, and further reducing the parasitic capacitance formed between the eighth signal line a8 and the sweep signal line SWEEP.

As shown in FIGS. 16 to 21 and FIGS. 25 to 30, in one or more embodiments, the pulse width compensation transistor PWM_M4 is connected to the pulse width storage capacitor PWM_C1 through the eighth signal line a8 extending in the second direction Y, and the second sweep signal line PWM_S2 extends in the first direction X. In the direction perpendicular to the plane where the base substrate is located, an overlapping region of the eighth signal line a8 and the second scan signal line PWM_S2 is a thirteenth region Z13. A line width of the eighth signal line a8 in the thirteenth region Z13 is set to be less than a line width of the eighth signal line a8 in a region other than the thirteenth region Z13, to narrow the eighth signal line a8 in the thirteenth region Z13, thereby reducing an overlapping area between the eighth signal line a8 and the second scan signal line PWM_S2, and further reducing the parasitic capacitance formed between the eighth signal line a8 and the second scan signal line PWM_S2.

As shown in FIGS. 16 to 21, in one or more embodiments, the ninth transistor PAM_M9 is connected to the first power line PWM_VDD through a ninth signal line a9 extending in the second direction Y, the pulse width light-emitting control signal line PWM_EM extends in the first direction X, the third reset signal line PAM_INIT extends in the first direction X, the second reset signal line PAM_REF extends in the first direction X, and the third scan signal line PAM_S1 extends in the first direction X. In the direction perpendicular to the plane where the base substrate is located, an overlapping region of the ninth signal line a9 and the pulse width light-emitting control signal line PWM_EM is a fifteenth region Z15, an overlapping region of the ninth signal line a9 and the third reset signal line PAM_INIT is a sixteenth region Z16, an overlapping region of the ninth signal line a9 and the second reset signal line PAM_REF is a seventeenth region Z17, and an overlapping region of the ninth signal line a9 and the third scan signal line PAM_S1 is an eighteenth region Z18. A Line width of the ninth signal line a9 in the fifteenth region Z15, the sixteenth region Z16, the seventeenth region Z17 and the eighteenth region Z18 is set to be less than a line width of the ninth signal line a9 in a region other than the fifteenth region Z15, the sixteenth region Z16, the seventeenth region Z17 and the eighteenth region Z18, to narrow the ninth signal line a9 in the fifteenth region Z15, the sixteenth region Z16, the seventeenth region Z17 and the eighteenth region Z18, thereby reducing an overlapping area between the ninth signal line a9 and the pulse width light-emitting control signal line PWM_EM, the third reset signal line PAM_INIT, the second reset signal line PAM_REF and the third scan signal line PAM_S1. S1, and further reducing the parasitic capacitance formed between the ninth signal line a9, the pulse width light-emitting control signal line PWM_EM, the third reset signal line PAM_INIT, the second reset signal line PAM_REF and the third scan signal line PAM_S1.

With continued reference to FIGS. 7, 21 and 30, in one or more embodiments, an overlapping region exists between the wire extending in the first direction X and the wire extending in the second direction Y. In the overlapping region, an aperture is provided in the wire extending in the first direction X, and an overlap exists between the aperture and the wire extending in the second direction Y in the direction perpendicular to the plane where the base substrate is located, and/or an aperture is provided in the wire extending in the second direction Y, and an overlap exists between the aperture and the wire extending in the first direction X in the direction perpendicular to the plane where the base substrate is located, to reduce the overlapping area between the wire extending in the first direction X and the wire extending in the second direction Y, thereby reducing the parasitic capacitance formed between the wire extending in the first direction X and the wire extending in the second direction Y, and further reducign the unwanted coupling power consumption. Moreover, the mutual interference of voltages between the wire extending in the first direction X and the wire extending in the second direction Y can also be reduced, thereby helping to achieve the accurate control of the potential of each node, reducing the control difficulty of the pixel driving circuit 11, and further facilitating improving the driving capability of the pixel driving circuit 11.

In an example, as shown in FIGS. 16 to 21 and FIGS. 25 to 30, in one or more embodiments, the second amplitude light-emitting control transistor PAM_M6 is connected to the light-emitting element through a seventh signal line a7 extending in the second direction Y, and the amplitude light-emitting control signal line PAM_EM extends in the first direction X. In the direction perpendicular to the plane where the base substrate is located, an overlapping region of the seventh signal line a7 and the amplitude light-emitting control signal line PAM_EM is an eleventh region Z11. The amplitude light-emitting control signal line PAM_EM is provided with a first aperture h1 in the eleventh region Z11, and the first aperture h1 at least partially overlaps the seventh signal line a7 in the direction perpendicular to the plane where the base substrate is located, thereby reducing an overlapping area between the amplitude light-emitting control signal line PAM_EM and the seventh signal line a7, and further reducing the parasitic capacitance formed between the amplitude light-emitting control signal line PAM_EM and the seventh signal line a7.

As shown in FIGS. 16 to 21, in one or more embodiments, the amplitude data signal line PAM_DATA extends in the second direction Y, and the amplitude light-emitting control signal line PAM_EM extends in the first direction X. In the direction perpendicular to the plane where the base substrate is located, an overlapping region of the amplitude data signal line PAM_DATA and the amplitude light-emitting control signal line PAM_EM is a tenth region Z10. The amplitude light-emitting control signal line PAM_EM is provided with a second aperture h2 in the tenth region Z10, and the second aperture h2 at least partially overlaps the amplitude data signal line PAM_DATA in the direction perpendicular to the plane where the base substrate is located, thereby reducing an overlapping area between the amplitude light-emitting control signal line PAM_EM and the amplitude data signal line PAM_DATA, and further reducing the parasitic capacitance formed between the amplitude light-emitting control signal line PAM_EM and the amplitude data signal line PAM_DATA.

As shown in FIGS. 16 to 21, in one or more embodiments, the first terminal PWM_M31 of the pulse width drive transistor PWM_M3 is connected to the first pulse width light-emitting control transistor PWM_M1 through the third signal line a3 extending in the second direction Y, and the first power line PWM_VDD extends in the first direction X. In the direction perpendicular to the plane where the base substrate is located, the overlapping region of the third signal line a3 and the first power line PWM_VDD is a third region Z3. The first power line PWM_VDD is provided with a third aperture h3 in the third region Z3, and the third aperture h3 at least partially overlaps the third signal line a3 in the direction perpendicular to the plane where the base substrate is located, thereby reducing an overlapping area between the first power line PWM_VDD and the third signal line a3 and further reducing the parasitic capacitance formed between the first power line PWM_VDD and the third signal line a3.

As shown in FIGS. 16 to 21, in one or more embodiments, the second pulse width light-emitting control transistor PWM_M6 is connected to the second terminal PWM_M32 of the pulse width drive transistor PWM_M3 through the fourth signal line a4 extending in the second direction Y, and the first power line PWM_VDD extends in the first direction X. In the direction perpendicular to the plane where the base substrate is located, an overlapping region of the fourth signal line a4 and the first power line PWM_VDD is a fifth region Z5. The first power line PWM_VDD is provided with a fourth aperture h4 in the fifth region Z5, and the fourth aperture h4 at least partially overlaps the fourth signal line a4 in the direction perpendicular to the plane where the base substrate is located, thereby reducing an overlapping area between the first power line PWM_VDD and the fourth signal line a4, and further reducing the parasitic capacitance formed between the first power line PWM_VDD and the fourth signal line a4.

As shown in FIGS. 16 to FIG. 21, in one or more embodiments, the pulse width data write transistor PWM_M2 is connected to the first terminal PWM_M31 of the pulse width drive transistor PWM_M3 through the first signal line a1 extending in the second direction Y, and the sweep signal line SWEEP extends in the first direction X. In the direction perpendicular to the plane where the base substrate is located, an overlapping region of the first signal line a1 and the sweep signal line SWEET is the first region Z1. The sweep signal line SWEEP is provided with a fifth aperture h5 in the first region Z1, and the fifth aperture h5 at least partially overlaps the first signal line a1 in the direction perpendicular to the plane where the base substrate is located, thereby reducing an overlapping area between the sweep signal line SWEEP and the first signal line a1, and further reducing the parasitic capacitance formed between the sweep signal line SWEEP and the first signal line a1.

As shown in FIGS. 16 to FIG. 21, in one or more embodiments, the pulse width compensation transistor PWM_M4 is connected to the second terminal PWM_M32 of the pulse width drive transistor PWM_M3 through the second signal line a2 extending in the second direction Y, and the sweep signal line SWEEP extends in the first direction X. In the direction perpendicular to the plane where the base substrate is located, an overlapping region of the second signal line a2 and the sweep signal line SWEEP is a second region Z2. The sweep signal line SWEEP is provided with a sixth aperture h6 in the second region Z2, and the sixth aperture h6 at least partially overlaps the second signal line a2 in the direction perpendicular to the plane where the base substrate is located, thereby reducing an overlapping area between the sweep signal line SWEEP and the second signal line a2, and further reducing the parasitic capacitance formed between the sweep signal line SWEEP and the second signal line a2.

As shown in FIGS. 16 to FIG. 21, in one or more embodiments, the pulse width compensation transistor PWM_M4 is connected to the pulse width storage capacitor PWM_C1 through the eighth signal line a8 extending in the second direction Y, and the sweep signal line SWEEP extends in the first direction X. In the direction perpendicular to the plane where the base substrate is located, an overlapping region of the eighth signal line a8 and the sweep signal line SWEEP is a twelfth region Z12. The sweep signal line SWEEP is provided with a seventh aperture h7 in the twelve region Z12, and the seventh aperture h7 at least partially overlaps the eighth signal line a8 in the direction perpendicular to the plane where the base substrate is located, thereby reducing an overlapping area between the sweep signal line SWEEP and the eighth signal line a8, and further reducing the parasitic capacitance formed between the sweep signal line SWEEP and the eighth signal line a8.

As shown in FIGS. 16 to 21, in one or more embodiments, the pulse width data signal line PWM_DATA extends in the second direction Y, and the sweep constant voltage signal line SWEEP_GND extends in the first direction X. In the direction perpendicular to the plane where the base substrate is located, an overlapping region of the pulse width data signal line PWM_DATA and the sweep constant voltage signal line SWEEP_GND is a fourteenth region Z14. The sweep constant voltage signal line SWEEP_GND is provided with an eighth aperture h8 in the fourteenth region Z14, and the eighth aperture h8 at least partially overlaps the pulse width signal line PWM_DATA in the direction perpendicular to the plane where the base substrate is disposed, thereby reducing an overlapping area between the sweep constant voltage signal line SWEEP_GND and the pulse width data signal line PWM_DATA, and further reducing the parasitic capacitance formed between the sweep constant voltage signal line SWEEP_GND and the pulse width data signal line PWM_DATA.

As shown in FIGS. 16 to 21, in one or more embodiments, the ninth transistor PAM_M9 is connected to the first power line PWM_VDD through the ninth signal line a9 extending in the second direction Y, and the third reset signal line PAM_INIT extends in the first direction X. In the direction perpendicular to the plane where the base substrate is located, an overlapping region between the ninth signal line a9 and the third reset signal line PAM_INIT is a sixteenth region Z16. The third reset signal line PAM_INIT is provided with a ninth aperture h9 in the sixteenth region Z16, and the ninth aperture h9 at least partially overlaps the ninth signal line a9 in the direction perpendicular to the plane where the base substrate is located, thereby reducing an overlapping area between the third reset signal line PAM_INIT and the ninth signal line a9, and further reducing the parasitic capacitance formed between the third reset signal line PAM_INIT and the ninth signal line a9.

With continued reference to FIGS. 16 to 21, in one or more embodiments, the first plate PAM _c11 of the amplitude storage capacitor PAM_C1 at least partially overlaps the second plate PAM_c12 of the amplitude storage capacitor PAM_C1 in the direction perpendicular to the plane where the base substrate is located. The first plate PAM_c11 includes a first opening structure 61, and the second plate PAM_c12 includes a second opening structure 62. In the direction perpendicular to the plane where the base substrate is located, the first opening structure 61 at least partially overlaps the second opening structure 62, so that the light transmittance of the display panel can be improved.

With continued reference to FIGS. 16 to 21, in one or more embodiments, a first plate PWM_c11 of the pulse width storage capacitor PWM_C1 at least partially overlaps the second plate PWM_c12 of the pulse width storage capacitor PWM_C1 in the direction perpendicular to the plane where the base substrate is located. The first plate PWM _c11 includes a third opening structure 63, and the second plate PWM_c12 includes a fourth opening structure 64. In the direction perpendicular to the plane where the base substrate is located, the third opening structure 63 at least partially overlaps the fourth opening structure 64, so that the light transmittance of the display panel can be improved.

With continued reference to FIGS. 15 to 30, in one or more embodiments, the first plate PAM_c11 of the amplitude storage capacitor PAM_C1 may be located in the third metal layer MC, and the second plate PAM_c12 of the amplitude storage capacitor PAM_C1 may be located in the second metal layer GAT. In the direction perpendicular to the plane where the base substrate is located, the first plate PAM_c11 of the amplitude storage capacitor PAM_C1 overlies the second plate PAM_c12 of the amplitude storage capacitor PAM_C1. In the direction parallel to the plane where the base substrate is located, a distance between a boundary of the first plate PAM_c11 of the amplitude storage capacitor PAM_C1 and a boundary of the second plate PAM_c12 of the amplitude storage capacitor PAM_C1 is greater than 0, such as greater than or equal to 0.5 µm, or further greater than or equal to 1 µm. With the arrangement, when the position alignment between the first plate PAM_c11 of the amplitude storage capacitor PAM_C1 and the second plate PAM_c12 of the amplitude storage capacitor PAM_C1 is inaccurate due to the process error, a sufficient overlapping area is ensured between the first plate PAM_c11 of the amplitude storage capacitor PAM_C1 and the second plate PAM_c12 of the amplitude storage capacitor PAM_C1, and thus the stability of the capacitance value of the amplitude storage capacitor PAM_C1 is improved.

Similarly, as shown in FIGS. 15 to 30, in one or more embodiments, the first plate PWM_c11 of the pulse width storage capacitor PWM_C1 may be located in the third metal layer MC, and the second plate PWM_c12 of the pulse width storage capacitor PWM_C1 may be located in the second metal layer GAT. In the direction perpendicular to the plane where the base substrate is located, the first plate PWM _c11 of the pulse width storage capacitor PWM_C1 overlies the second plate PWM_c12 of the pulse width storage capacitor PWM_C1. In the direction parallel to the plane where the base substrate is located, a distance between a boundary of the first plate PWM_c11 of the pulse width storage capacitor PWM_C1 and a boundary of the second plate PWM_c12 of the pulse width storage capacitor PWM_C1 is greater than 0, such as greater than or equal to 0.5 µm, or further greater than or equal to 1 µm. With the arrangement, when the position alignment between the first plate PWM_C11 of the pulse width storage capacitor PWM_C1 and the second plate PWM_C12 of the pulse width storage capacitor PWM_C1 is inaccurate due to the process error, a sufficient overlapping area is ensured between the first plate PWM_C11 of the pulse width storage capacitor PWM_C1 and the second plate PWM_C12 of the pulse width storage capacitor PWM_C1, and thus the stability of the capacitance value of the pulse width storage capacitor PWM_C1 is improved.

With continued reference to FIGS. 7, 21 and 30, in one or more embodiments, in the amplitude adjustment module PAM, the amplitude storage capacitor PAM_C1 and the amplitude drive transistor PAM_M3 are arranged in the second direction Y. In the second direction Y, the first amplitude light-emitting control transistor PAM_M1 and the second amplitude light-emitting control transistor PAM_M6 are located on a side of the amplitude drive transistor PAM_M3 away from the amplitude storage capacitor PAM_C1, and the first amplitude light-emitting control transistor PAM_M1 and the second amplitude light-emitting control transistor PAM_M6 are arranged in the first direction X. An arrangement direction of the first amplitude light-emitting control transistor PAM_M1 and the second amplitude light-emitting control transistor PAM_M6 is the same as an arrangement direction of the first pulse width light-emitting control transistor PWM_M1 and the second pulse width light-emitting control transistor PWM_M6. With the arrangement, it is conducive to making the layout of the pixel driving circuit 11 more compact, thereby saving the space, which is not limited thereto and is not limited in the embodiments of the present disclosure.

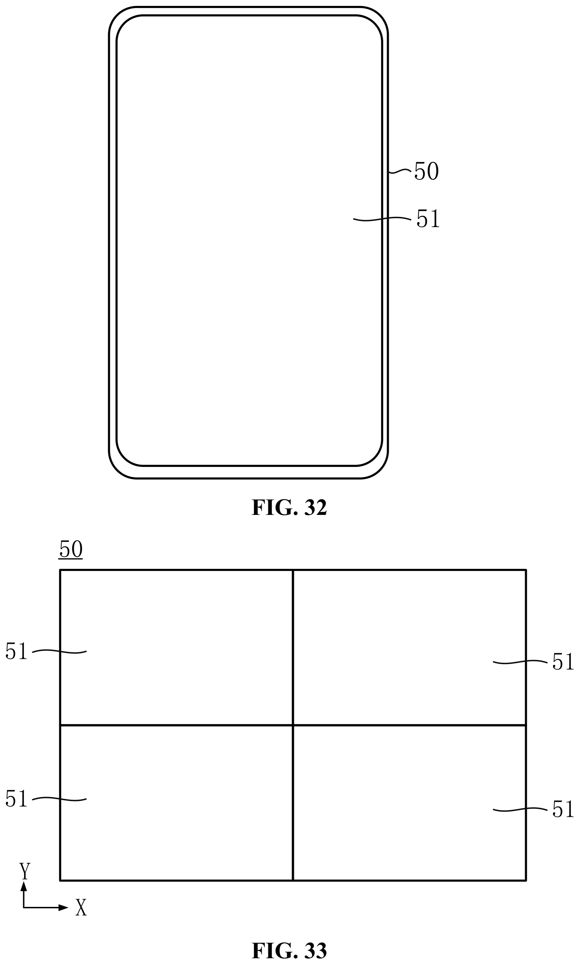

Based on the same inventive conception, an embodiment of the present disclosure further provides a display device. FIG. 32 is a schematic structural diagram of a display device according to an embodiment of the present disclosure. As shown in FIG. 32, the display device 50 includes the display panel 51 described in any of the embodiments of the present disclosure. Therefore, the display device 50 provided in the embodiments of the present disclosure has the technical effects of the technical solutions in any one of the embodiments described above, and the same or corresponding structures and terms as those in the above-described embodiments are not repeated herein.

FIG. 33 is another schematic structural diagram of a display device according to an embodiment of the present disclosure. As shown in FIG. 33, the display device provided in the embodiments of the present disclosure may be a spliced display device, such as a borderless spliced display device, and the spliced display device includes at least two of the above-described display panels 51 to be suitable for a large-screen display device with display functions.

At least two display panels 51 may be arranged in the first direction X, or at least two display panels 51 may be arranged in the second direction Y, which is not limited thereto and is not limited in the embodiments of the present disclosure.

The display device 50 provided in the embodiments of the present disclosure may be a cellular phone as shown in FIG. 31, or a spliced display device as shown in FIG. 32, or any electronic product having the display function. The electronic product includes, but not limited to, the following categories: a television, a notebook computer, a desktop display, a tablet computer, a digital camera, an intelligent bracelet, intelligent glasses, a vehicle-mounted display, a medical equipment, an industrial control equipment, a touch interaction terminal and the like, which is not limited in the embodiments of the present disclosure.

It is to be understood that various forms of the flows, the reordering step, the adding step or the deleting step shown above may be used. For example, as long as the desired results of the technical solutions of the present disclosure can be achieved, the steps recited in the present disclosure may be executed in parallel, sequentially or in different orders, which is not limited herein.

The above specific implementations should not be construed as limiting the scope of protection of the present disclosure. It is to be understood by those skilled in the art that various modifications, combinations, sub-combinations and substitutions may be made depending on design requirements and other factors. Any modification, equivalent replacement, and improvement made within the principle of the present disclosure should be included within the scope of protection of the present disclosure.

## Claims

1. A display panel, comprising:
a base substrate and a pixel driving circuit located on a side of the base substrate;
wherein the pixel driving circuit comprises a first drive transistor,
the first drive transistor comprises a first electrode and a second electrode,
the first electrode comprises a first section extending in a first direction,
the second electrode comprises a second section extending in a second direction, and
the first direction intersects with the second direction;
wherein the first section comprises a first segment and a second segment arranged in the first direction, and a vertical projection of the second segment on the base substrate overlaps a vertical projection of the second section on the base substrate; and
wherein in the first direction, an area per unit length of the second segment is less than an area per unit length of the first segment .

2. The display panel of claim 1, wherein the first electrode is a gate, and the second electrode is a source or a drain.

3. The display panel of claim 1 or 2, wherein the second segment comprises a first connection portion connected to the first segment; and
a length of the first connection portion in the second direction is d1, and a length of the first segment in the second direction is D, wherein d1 < D.

4. The display panel of claim 3, wherein the second segment further comprises a second connection portion connected to the first segment; and
a length of the second connection portion in the second direction is d2, wherein d1 + d2 < D.

5. The display panel of claim 4, wherein the first connection portion and the second connection portion are arranged in the second direction, and a first hollow portion is disposed between the first connection portion and the second connection portion; and
a vertical projection of the first hollow portion on the base substrate overlaps the vertical projection of the second section on the base substrate.

6. The display panel of claim 1 or 2, wherein a length of the second segment in the second direction is equal to a length of the first segment in the second direction; and
the second segment comprises at least one second hollow portion, and a vertical projection of the at least one second hollow portion on the base substrate overlaps the vertical projection of the second section on the base substrate.

7. The display panel of claim 1 or 2, wherein the pixel driving circuit further comprises a first capacitor and the first capacitor comprises a first plate;
the first electrode further comprises a third section extending in the second direction, the first section is connected to the third section, and the second section and the third section are arranged in the first direction;
the first plate comprises a first connection section connected to the third section, and the third section and the first connection section are arranged in the second direction; and
in the first direction, a spacing between the third section and the second section is greater than a spacing between the first connection section and the second section.

8. The display panel of claim 7, wherein a length of the third section in the first direction is less than a length of the first connection section in the first direction.

9. The display panel of claim 7, wherein a boundary of the third section on a side close to the second section is a first boundary and a boundary of the third section on a sideaway from the second section is a second boundary;
a boundary of the first connection section on a side close to the second section is a third boundary, and a boundary of the first connection section on a side away from the second section is a fourth boundary; and
in the first direction, the first boundary is located on a side of the third boundary away from the second subsection, and the second boundary is located on a side of the fourth boundary close to the second subsection.

10. The display panel of claim 7, wherein a boundary of the third section on a side close to the second section is a first boundary and the first boundary extends in the second direction;
a boundary of the first connection section on a side close to the second section is a third boundary, and the third boundary extends in the second direction;
the first connection section comprises a first chamfered boundary, and the first chamfered boundary is connected to the third boundary and the first boundary; and
an included angle between the first chamfered boundary and the third boundary is an obtuse angle, and an included angle between the first chamfered boundary and the first boundary is an obtuse angle.

11. The display panel of claim 9 or 10, wherein the second boundary extends in the second direction;
the fourth boundary extends in the second direction;
the first connection section comprises a second chamfered boundary, and the second chamfered boundary is connected to the fourth boundary and the second boundary; and
an included angle between the second chamfered boundary and the fourth boundary is an obtuse angle, and an included angle between the second chamfered boundary and the second boundary is an obtuse angle.

12. The display panel of claim 1 or 2, wherein the pixel driving circuit further comprises a first capacitor and the first capacitor comprises a first plate;
the first electrode further comprises a third section extending in the second direction, the first section is connected to the third section, and the second section and the third section are arranged in the first direction;
a boundary of the first section on a side close to the first capacitor is a fifth boundary, and the fifth boundary extends in the first direction;
a boundary of the third section on a side close to the second section is a first boundary, and the first boundary extends in the second direction; and
the fifth boundary is contiguous with the first boundary.

13. The display panel of claim 1 or 2, wherein the pixel driving circuit further comprises a first capacitor and the first capacitor comprises a first plate;
a boundary of the second section on a side close to the first plate in the first direction is a sixth boundary, and the sixth boundary extends in the second direction;
a boundary of the second section on a side close to the first plate in the second direction is a seventh boundary, and the seventh boundary extends in the first direction;
the second section comprises a third chamfered boundary, and the third chamfered boundary is connected to the sixth boundary and the seventh boundary; and
an included angle between the third chamfered boundary and the sixth boundary is an obtuse angle, and an included angle between the third chamfered boundary and the seventh boundary is an obtuse angle.

14. The display panel of claim 13, wherein the first plate comprises a main body section and a first connection section connected to each other, and the main body section and the first connection section are arranged in the second direction;
the second section and the first connection section are arranged in the first direction, and the second section and the main body section are arranged in the second direction;
a boundary of the first connection section on a side close to the second section is a third boundary, and the third boundary extends in the second direction;
a boundary of the main body section on a side close to the second section is an eighth boundary, and the eighth boundary extends in the first direction;
the first plate further comprises a fourth chamfered boundary, and the fourth chamfered boundary is connected to the third boundary and the eighth boundary; and
an included angle between the fourth chamfered boundary and the third boundary is an obtuse angle, and an included angle between the fourth chamfered boundary and the eighth boundary is an obtuse angle.

15. The display panel of claim 1 or 2, wherein the pixel driving circuit further comprises a pulse width adjustment module and an amplitude adjustment module;
the pulse width adjustment module comprises a pulse width drive transistor, the amplitude adjustment module comprises an amplitude drive transistor, and the pulse width drive transistor is electrically connected to a gate of the amplitude drive transistor; and
the first drive transistor comprises at least one of the amplitude drive transistor or the pulse width drive transistor.

16. The display panel of claim 15, wherein the first drive transistor is the amplitude drive transistor;
a spacing between a vertical projection of a gate of the pulse width drive transistor on the base substrate and a vertical projection of a first terminal of the pulse width drive transistor on the base substrate is greater than 0; and
a spacing between the vertical projection of the gate of the pulse width drive transistor on the base substrate and a vertical projection of a second terminal of the pulse width drive transistor on the base substrate is greater than 0.

17. The display panel of claim 16, wherein the pulse width adjustment module further comprises a first pulse width light-emitting control transistor, a second pulse width light-emitting control transistor, and a pulse width storage capacitor;
a first terminal of the first pulse width light-emitting control transistor is electrically connected to a first power line, a second terminal of the first pulse width light-emitting control transistor is electrically connected to the first terminal of the pulse width drive transistor, and a gate of the first pulse width light-emitting control transistor is electrically connected to a pulse width light-emitting control signal line;
a first terminal of the second pulse width light-emitting control transistor is electrically connected to the second terminal of the pulse width drive transistor, a second terminal of the second pulse width light-emitting control transistor is electrically connected to the amplitude adjustment module, and a gate of the second pulse width light-emitting control transistor is electrically connected to the pulse width light-emitting control signal line;
the pulse width storage capacitor is electrically connected to the gate of the pulse width drive transistor;
in the second direction, the first pulse width light-emitting control transistor and the second pulse width light-emitting control transistor are located on a side of the second terminal of the pulse width drive transistor away from the first terminal of the pulse width drive transistor; and
in the first direction, an arrangement direction of the first pulse width light-emitting control transistor and the second pulse width light-emitting control transistor is the same as an arrangement direction of the pulse width drive transistor and the pulse width storage capacitor.

18. The display panel of claim 17, wherein the first power line extends in the first direction; and in the second direction, the first pulse width light-emitting control transistor and the second pulse width light-emitting control transistor are located on a side of the first power line away from the pulse width drive transistor.

19. The display panel of claim 16, wherein the pulse width adjustment module further comprises a pulse width compensation transistor, a pulse width gate reset transistor and a pulse width storage capacitor;
a first terminal of the pulse width compensation transistor is electrically connected to the second terminal of the pulse width drive transistor, a second terminal of the pulse width compensation transistor is electrically connected to the gate of the pulse width drive transistor, and a gate of the pulse width compensation transistor is electrically connected to a second scan signal line;
a first terminal of the pulse width gate reset transistor is electrically connected to a first reset signal line, a second terminal of the pulse width gate reset transistor is electrically connected to the gate of the pulse width drive transistor, and a gate of the pulse width gate reset transistor is electrically connected to a first scan signal line;
the pulse width storage capacitor is electrically connected to a gate of the pulse width driver transistor;
in the second direction, the pulse width compensation transistor and the pulse width gate reset transistor are located on a side of the first terminal of the pulse width drive transistoraway from the second terminal of the pulse width drive transistor; and
in the first direction, an arrangement direction of the pulse width gate reset transistor and the pulse width compensation transistor is the same as an arrangement direction of the pulse width drive transistor and the pulse width storage capacitor.

20. The display panel of claim 16, wherein the gate of the pulse width drive transistor comprises a fourth section extending in the first direction and a fifth section extending in the second direction, the fourth section and the fifth section are connected to each other, and the fourth section and the fifth section are arranged in the first direction;
in the second direction, a boundary of the fourth section on a side close to the first terminal of the pulse width drive transistor is a ninth boundary, and the ninth boundary extends in the first direction;
in the first direction, a boundary of the fifth section on a side close to the first terminal of the pulse width drive transistor is a tenth boundary, and the tenth boundary extends in the second direction; and
the ninth boundary is contiguous with the tenth boundary.

21. The display panel of claim 16, wherein the gate of the pulse width drive transistor comprises a fourth section extending in the first direction and a fifth section extending in the second direction, the fourth section and the fifth section are connected to each other, and the fourth section and the fifth section are arranged in the first direction;
the pulse width adjustment module further comprises a pulse width storage capacitor, and the pulse width storage capacitor comprises a second plate;
the second plate comprises a second connection section connected to the fifth section, and the fifth section and the second connection section are arranged in the second direction; and
in the first direction, a spacing between the fifth section and the first terminal of the pulse width drive transistor is greater than a spacing between the second connection section and the first terminal of the pulse width drive transistor.

22. A display device comprising the display panel of any one of claims 1 to 21.
